# EUROPEAN PATENT SPECIFICATION

(11) **EP 4 341 310 B1**
(45) Date of publication and mention of the grant of the patent: **25.06.2025**
(21) Application number: 22729526.8
(22) Date of filing: 16.05.2022
(51) Int. Cl.: C08F 212/08, C08F 212/32, C08F 220/18, C09D 125/14, G03F 7/00

(54) **HYDROPHOBIC CROSSLINKABLE PINNING UNDERLAYERS WITH IMPROVED DRY ETCH CAPABILITIES FOR PATTERNING DIRECTED SELF-ASSEMBLY OF PS-B-PMMA TYPE BLOCK COPOLYMERS**
HYDROPHOBE VERNETZBARE PINNING-UNTERSCHICHTEN MIT VERBESSERTEN TROCKENÄTZFÄHIGKEITEN ZUR STRUKTURIERUNG DER GERICHTETEN SELBSTANORDNUNG VON PS-B-PMMA-BLOCKCOPOLYMEREN
SOUS-COUCHES D'ANCRAGE RÉTICULABLES HYDROPHOBES AYANT DES CAPACITÉS DE GRAVURE À SEC AMÉLIORÉES POUR MODÉLISATION D'AUTO-ASSEMBLAGE DIRIGÉ DE COPOLYMÈRES SÉQUENCÉS DE TYPE PS-B-PMMA

(30) Priority: 18.05.2021 US 202163189803 P
(43) Date of publication of application: 27.03.2024
(73) Proprietor: Merck Patent GmbH, 64293 Darmstadt (DE)
(72) Inventor: BASKARAN, Durairaj, Branchburg, New Jersey 08876 (US); MOORE, Ashley, Branchburg, New Jersey 08876 (US); MONREAL, Victor, Branchburg, New Jersey 08876 (US); LI, Zhong, Branchburg, NJ 08876 (US)
(74) Representative: Rippel, Hans Christoph
(86) International application number: PCT/EP2022/063127
(87) International publication number: WO 2022/243216

(56) References cited:
- EP-A1- 3 480 223
- JP-A- 2017 110 150
- US-A1- 2013 078 576
- US-A1- 2015 287 592
- US-B1- 9 574 104

## Description

### FIELD OF INVENTION

The invention relates to novel styrenic polymers, novel compositions and novel methods for using the novel compositions for aligning microdomains of directed self-assembling block copolymers (BCP). The compositions and processes are useful for fabrication of electronic devices.

### BACKGROUND

Directed self-assembly (DSA) of block copolymers is a method useful for generating smaller and smaller patterned features for the manufacture of microelectronic devices in which the critical dimensions (CD) of features on the order of nanoscale can be achieved. Directed self-assembly methods are desirable for extending the resolution capabilities of microlithographic technology. In a conventional lithography approach, ultraviolet (UV) radiation may be used to expose through a mask onto a photoresist layer coated on a substrate or layered substrate. Positive or negative photoresists are useful, and these can also contain a refractory element such as silicon to enable dry development with conventional integrated circuit (IC) plasma processing. In a positive photoresist, UV radiation transmitted through a mask causes a photochemical reaction in the photoresist such that the exposed regions are removed with a developer solution or by conventional IC plasma processing. Conversely, in negative photoresists, UV radiation transmitted through a mask causes the regions exposed to radiation to become less removable with a developer solution or by conventional IC plasma processing. An integrated circuit feature, such as a gate, via or interconnect, is then etched into the substrate or layered substrate, and the remaining photoresist is removed. When using conventional lithographic exposure processes, the dimensions of features of the integrated circuit feature are limited. Further reduction in pattern dimensions are difficult to achieve with radiation exposure due to limitations related to aberrations, focus, proximity effects, minimum achievable exposure wavelengths and maximum achievable numerical apertures. The need for large-scale integration has led to a continued shrinking of the circuit dimensions and features in the devices. In the past, the final resolution of the features has been dependent upon the wavelength of light used to expose the photoresist, which has its own limitations. Direct assembly techniques, such as graphoepitaxy and chemoepitaxy using block copolymer imaging, are highly desirable techniques used to enhance resolution while reducing CD variation. These techniques can be employed to either enhance conventional UV lithographic techniques or to enable even higher resolution and CD control in approaches employing EUV, e-beam, deep UV or immersion lithography. The directed self-assembly block copolymer comprises a block of etch resistant copolymeric unit and a block of highly etchable copolymeric unit, which when coated, aligned and etched on a substrate give regions of very high-density patterns. In the graphoepitaxy directed self-assembly method, the block copolymers self organizes around a substrate that is pre-patterned with conventional lithography (e.g., Ultraviolet, Deep UV, e-beam, Extreme UV (EUV) exposure source) to form repeating topographical features such as a line/space (L/S) or contact hole (CH) pattern. In an example of a L/S directed self-assembly array, the block copolymer can form self-aligned lamellar regions which can form parallel line-space patterns of different pitches in the trenches between pre-patterned lines, thus enhancing pattern resolution by sub-dividing the space in the trench between the topographical lines into finer patterns. For example, a diblock copolymer which is capable of microphase separation and comprises a block rich in carbon (e.g., styrene or containing some other element like Si, Ge, Ti) which is resistant to plasma etch, and a block which is highly plasma etchable or removable, can provide a high-resolution pattern definition. Examples of highly etchable blocks can comprise monomers which are rich in oxygen and which do not contain refractory elements and are capable of forming blocks which are highly etchable, such as methyl methacrylate. The plasma etching gases used in the etching process of defining the self-assembly pattern typically are those used in processes employed to make integrated circuits (IC). In this manner very fine patterns can be created in typical IC substrates than were definable by conventional lithographic techniques, thus achieving pattern multiplication. Similarly, features such as contact holes can be made denser by using graphoepitaxy in which a suitable block copolymer arranges itself by directed self-assembly around an array of contact holes or posts defined by conventional lithography, thus forming a denser array of regions of etchable and etch resistant domains which when etched give rise to a denser array of contact holes. Consequently, graphoepitaxy has the potential to offer both pattern rectification and pattern multiplication.

In chemical epitaxy or pinning chemical epitaxy (a.k.a. chemoepitaxy) the self-assembly of the block copolymer is formed around a surface that has regions of differing chemical affinity but no or very slight topography to guide the self-assembly process. For example, the surface of a substrate could be patterned with conventional lithography (e.g., UV, Deep UV, e-beam EUV) to create surfaces of different chemical affinity in a line and space (L/S) pattern in which exposed areas whose surface chemistry had been modified by irradiation alternate with areas which are unexposed and show no chemical change. These areas present no topographical difference but do present a surface chemical difference or pinning to direct self-assembly of block copolymer segments. Specifically, the directed self-assembly of a block copolymer whose block segments contain etch resistant (such as styrene repeat unit) and rapidly etching repeat units (e.g., methyl methacrylate repeat units) would allow precise placement of etch resistant block segments and highly etchable block segments over the pattern. This technique allows for the precise placement of these block copolymers and the subsequent pattern transfer of the pattern into a substrate after plasma or wet etch processing. Chemical epitaxy has the advantage that it can be fine-tuned by changes in the chemical differences to help improve line edge roughness and CD control, thus allowing for pattern rectification. Other types of patterns such as repeating contact holes (CH) arrays could also be pattern rectified using chemoepitaxy.

Neutral layers are layers on a substrate, or the surface of a treated substrate, which have no affinity for either of the block segment of a block copolymer employed in directed self-assembly. In the graphoepitaxy method of directed self-assembly of block copolymer, neutral layers are useful as they allow the proper placement or orientation of block polymer segments for directed self-assembly which leads to proper placement of etch resistant block polymer segments and highly etchable block polymer segments relative to the substrate. For instance, in surfaces containing line and space features which have been defined by conventional radiation lithography, a neutral layer allows block segments to be oriented so that the block segments are oriented perpendicular to the surface of the substrates, an orientation which is ideal for both pattern rectification and pattern multiplication depending on the length of the block segments in the block copolymer as related to the length between the lines defined by conventional lithography. If a substrate interacts too strongly with one of the block segments it would cause it to lie flat on that surface to maximize the surface of contact between the segment and the substrate; such a surface would perturb the desirable perpendicular alignment which can be used to either achieve pattern rectification or pattern multiplication based on features created through conventional lithography. Modification of selected small areas or pinning of substrate to make them strongly interactive with one block of the block copolymer and leaving the remainder of the surface coated with the pinning MAT layer can be useful for forcing the alignment of the domains of the block copolymer in a desired direction, and this is the basis for the pinned chemoepitaxy or graphoepitaxy employed for pattern multiplication. The MAT layer is a crosslinked layer which is insoluble to any layer coated on top of it, which can be used as a DSA neutral or pinning layer.

Compositions containing standard crosslinking styrenic pinning MAT layer materials, have high plasma etch resistance, because they contain high amounts of aromatic hydrocarbons, and do not allow easy patterning using dry etch process to affect the developing of prepattern useful in directed self-assembly. Specifically, the problem associated with dry etch of standard crosslinking styrenic pinning MAT DSA underlayers useful for pattern multiplication of prepatterns, formed either by dry 193 nm or 193 nm immersion lithography's, or extreme ultraviolet (EUV) lithography is that the high etch resistance of these standard MAT materials used for either pattern multiplication or rectification compromises favorable topographic design of prepattern by generating DSA defects such as bridges, dislocations, and non-uniformity of block copolymer domains' critical dimension leading to edge placement errors. The problem associated with dry etch of a crosslinkable polystyrene underlayers in 193i litho-process (193 nm immersion lithography) compromises favorable topographic design of prepattern and generates DSA defects such as bridges containing bottom antireflective coating) substrates, standard styrenic pinning MAT layer compositions. US2013/078576 discloses in examples 1-4 random copolymers of styrene (I), vinylbenzocyclobutene (II) and methyl methacrylate (III).

### SUMMARY OF THE INVENTION

In order to enable easy processing of hydrophobic crosslinkable MAT underlayers for DSA prepattern development, for chemoepitaxy directed self-assembly processes, a series of new polystyrene copolymers which contain a small amount of polar copolymer have been synthesized. Specifically, several terpolymers containing styrene and 4-vinylbenzocyclobutene derived repeat units were developed, which also contain repeat units derived from a polar alkyl methacrylate or a methacrylate ester of arene moieties. The dry etch characterization of these novel terpolymers are tuned depending on which of these polar alkyl or arene comprising methacrylate were present and their concentrations. These new hydrophobic crosslinkable mat underlayers showed controlled prepattern topography and influenced positively the assembly of PS-b-PMMA block copolymers for line multiplication DSA process flow with more uniform domain sizes of PS and PMMA blocks.

One aspect of this invention is a random copolymer whose repeat units comprise repeat units of structure (I), (II) and (III), wherein R₁ and R₂ are independently a C-1 to C-4 alkyl, x and y are independently the number of R₁ and R₂ which independently range from an integer from 0 to 3, R₃ is a C-1 to C-4 alkyl, and R₄ is selected from a C-2 to C-10 primary alkyl, or a moiety comprising an arene selected from the group consisting of a substituted or unsubstituted biphenyl moiety, a substituted or unsubstituted phenyl moiety, and a substituted or unsubstituted benzylic moiety and m, n, and o are respectively the number of repeat units of structures (I), (II) and (III), where the mole % of the repeat unit of structure (I) ranges from about 60 mole % to about 95 mole %, the mole % of repeat unit of structure (II) ranges from about 5 mole % to about 25 mole %, the mole % of repeat unit of structure (III) ranges from about 2 mole % to about 18 mole %, where the sum of the mole % of these repeat units either is less than 100 mole %, if other different repeat units are present, or equals 100 mole % if only the repeat units of structures (I), (II) and (III) are present, and further where said random copolymer has a polydispersity ranging from about 1.25 to about 1.80 and has an Mw which ranges from about 30,000 to about 45, 000 Daltons, and said random copolymer is free of reactive end groups comprising a benzylic alcohol comprising moiety.

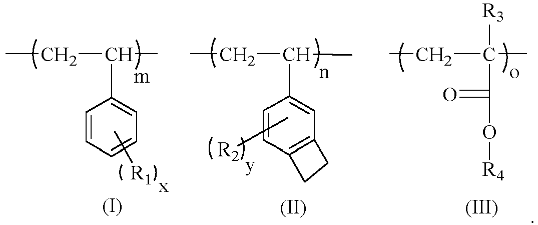

Another aspect of this invention is a composition comprising this random copolymer, and an organic spin casting solvent.

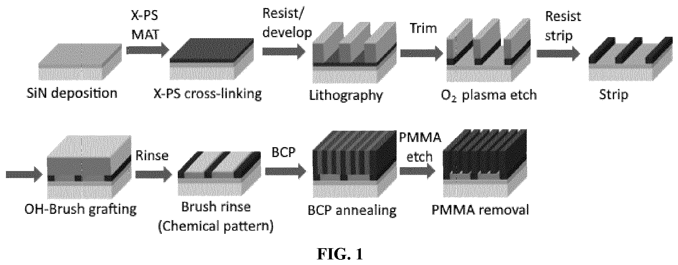

A further aspect of this invention is using a coating of this composition to form a patterned pinning MAT for use directed self-assembly. FIG. 1 shows one possible chemoepitaxy scheme which may be employed when using crosslinked pinning MAT layer formed by compositions comprising the novel random copolymer.

### BRIEF DESCRIPTION OF THE DRAWINGS

FIG. 1: Example of a suitable chemoepitaxy directed self-assembly scheme employing a crosslinked pinning MAT layer formed from the novel random copolymer whose repeat units comprising repeat units of structure (I), (II) and (III)
FIG. 2: Reference Comp Ex. 1 showing no neutrality to PS-b-PMMA and new materials Ex 1, 2, and 3 series (1 to 3 with different concentration of n-Butyl methacrylate monomer) showing similar behavior. Condition: Coat Ex. 1 to 3 and Comp Ex. 1, bake 250°C/30min/N₂, coat Neutral Brush 1, bake 250°C/30 min/N₂, 2min EBR rinse, dry bake, coat Block Copolymer 1, ctg 50 at 35 nm, anneal 250°C/30 min/N₂.
FIG. 3: Etch rate and Normalized etch rate comparison. Bulk etch improvements of Ex. 1, Ex. 2 and Ex. 3 compared to Comp Ex. 1. Condition: ACT12: 110°C/1 min, 250°C/30 min (N₂). Trion Etcher: Pressure = 70 mT; Top/Bottom (W) = 50/50; O₂ (sccm) = 50.
FIG. 4 Etch rate and Normalized etch rate comparison. Bulk etch improvements of Ex. 1, Ex. 2, Ex 11 and Ex 12 comparted to Comp Ex 1. Condition: ACT12: 110°C/1 min, 250°C/30min (N₂). Trion Etcher: Pressure = 70 mT; Top/Bottom (W) = 50/50 ; O₂ (sccm) = 50.
FIG. 5 Lithographic performance on P90 nm. Ex. 3 induces larger after development inspection (ADI) CD than pinning MAT layers from Ex. 1 and Ex 2 or Comp. Ex. 1.
FIG. 6: Lithographic performance on P90 nm. Ex. 3 induces larger After etch inspection (AEI) CD than Ex. 1 and Ex 2. or Comp. Ex. 1.
FIG. 7: DSA process window of polymers as pinning guides; Comparison of Comp Ex. 1 to Example Ex. 1, Ex. 2, and Ex 3.
FIG. 8: Average CD and 3σ of DSA lines formed with Comp. Ex. 1 & Ex 1, Ex 2 and Ex 3.
FIG. 9: Example of guided and unguided DSA lines formed and used for CD evaluation.

### DETAILED DESCRIPTION

It is to be understood that both the foregoing general description and the following detailed description are illustrative and explanatory, and are not restrictive of the subject matter, as claimed. In this application, the use of the singular includes the plural, the word "a" or "an" means "at least one," and the use of "or" means "and/or," unless specifically stated otherwise. Furthermore, the use of the term "including," as well as other forms such as "includes" and "included," is not limiting. Also, terms such as "element" or "component" encompass both elements and components comprising one unit and elements or components that comprise more than one unit, unless specifically stated otherwise. As used herein, the conjunction "and" is intended to be inclusive and the conjunction "or" is not intended to be exclusive unless otherwise indicated. For example, the phrase "or, alternatively" is intended to be exclusive. As used herein, the term "and/or" refers to any combination of the foregoing elements including using a single element.

Herein, "alkyl" refers to hydrocarbon groups which can be linear, branched (e.g., methyl, ethyl, propyl, isopropyl, tert-butyl and the like) or cyclic (e.g., cyclohexyl, cyclopropyl, cyclopentyl and the like).

"Alkyloxy" refers to an alkyl group as defined above on which is attached through an oxy (-O-) moiety (e.g., methoxy, ethoxy, propoxy, butoxy, 1,2-isopropoxy, cyclopentyloxy cyclohexyloxy and the like).

"Fluoroalkyl" refers to a linear, cyclic or branched saturated alkyl group as defined above in which the hydrogens have been replaced by fluorine either partially or fully (e.g., trifluoromethyl, perfluoroethyl, 2,2,2-trifluoroethyl, perfluoroisopropyl, perfluorocyclohexyl and the like).

"Fluoroalkyloxy" refers to a fluoroalkyl group as defined above on which is attached through an oxy (-O-) moiety (e.g., trifluoromethyloxy, perfluoroethyloxy, 2,2,2-trifluoroethoxy, perfluorocyclohexyloxy and the like).

Herein when referring to an alkyl, alkyloxy, fluoroalkyl, fluoroalkyloxy moieties with a possible range carbon atoms which starts with C-1 such as for instance "C-1 to C-10 alkyl," or "C-1 to C-10 fluoroalkyl," as a non-limiting examples, this range encompasses, primary alkyls, linear alkyls (a.k.a. n-alkyl), secondary alkyls, alkyloxy, fluoroalkyl and fluoroalkyloxy starting with C-1 but only designated branched alkyls, branched alkyloxy, cycloalkyl, cycloalkyloxy, branched fluoroalkyl, and cyclic fluoroalkyl starting with C-3.

The term "primary alkyl." denotes moieties whose attachment site as a substituent is a primary carbon where the rest of this substituent apart from the attachment point may either be H (a.k.a. methyl), a linear alkyl moiety (e.g. n-alkyl), a branched alkyl, or a cycloalkyl. Specific non limiting examples are methyl, ethyl, n-propyl, isopropyl, isobutyl, n-butyl, n-pentyl, 2-methylpentyl, 3-methylpentyl, n-hexyl, 2-methylhexyl, n-heptyl, 2-methylheptane, 3-methylheptane, n-octyl, (cyclohexyl)methyl, (CH₂-cyclohexyl), (cyclopentyl)methyl (CH₂-cyclopentyl). The further specification of a C-1 to C-10 primary alkyl denotes that these primary alkyls have C-1 to C-10 carbon atoms in total.

Herein the term "alkylene" refers to hydrocarbon groups which can be a linear, branched or cyclic which has two attachment points (e.g., methylene, ethylene, 1,2-isopropylene, a 1,4-cyclohexylene and the like). Here again, when designating a possible range of carbons, such as C-1 to C-20, as a non-limiting example, this range encompasses linear alkylenes starting with C-1 (a.k.a. methyl), but only designates branched alkylenes, or branched cycloalkylene starting with C-3. The term alkylene also encompasses unsubstituted alkylene (a.k.a. linear branched or cyclic alkylene with only hydrogen present), and substituted alkylenes (a.k.a. linear branched or cyclic alkylenes containing these substituents other than hydrogen), wherein these substituted alkylenes are ones wherein one or more hydrogens is replaced by a substituent selected from an aryl group, a halide, a C-1 to C-20 alkyl, or a C-1 to C-20 alkyloxy.

Herein the term "moiety comprising an arene," designated a monofunctional group which contains an arene which is chosen from a substituted or unsubstituted benzyl moiety, a substituted or unsubstituted biphenyl moiety and a substituted or unsubstituted phenyl moiety. In this context unsubstituted entails that only hydrogen is present, while the term substituted entails that at least one substituent is present selected from a halide, a C-1 to C-20 alkyl, a fluoroalkyl, a perfluoroalkyl, and a C-1 to C-20 alkyloxy or a mixture of these substituents.

Herein the term "aryl" refers to aromatic hydrocarbon moiety which has one attachment points, this moiety may be a single benzene moiety (e.g., phenyl), a polycyclic aromatic moiety with one attachment points such derived from naphthalene, anthracene, pyrene and the like, or a multiple benzene rings in a chain which have one attachment point (e.g., 1,4-biphenyl). The term "aryl" also encompasses the aforementioned moieties which are unsubstituted aryls (a.k.a. only hydrogen as substituents) or which are substituted aryls, wherein the substituent is a substituent selected from a halide, a C-1 to C-20 alkyl, or a C-1 to C-20 alkyloxy.

"Lo" is the block copolymer bulk repeat period, as defined in Erik W. Edwards et. al., Macromolecules 2007, 40, p 90-96.

If two linking moieties are adjacent to each other and both are designated as a single valence bond this designation represents a single linking moiety which is a single valence bond (e.g., if linking moieties L₁ and L₂ are both designated as a single valence bonds, this represents a single linking moiety which is a single valence bond).

One aspect of this invention is a random copolymer whose repeat units comprise repeat units of structure (I), (II) and (III), wherein R₁ and R₂ are independently a C-1 to C-4 alkyl, x and y are independently the number of R₁ and R₂ which independently range from an integer from 0 to 3, R₃ is a C-1 to C-4 alkyl, and R₄ is selected from a C-2 to C-10 primary alkyl, or a moiety comprising an arene selected from the group consisting of a substituted or unsubstituted biphenyl moiety, a substituted or unsubsituted phenyl moiety, and a substituted or unsubsituted benzylic moiety and m, n, and o are respectively the number of repeat units of structures (I), (II) and (III), where the mole % of the repeat unit of structure (I) ranges from about 60 mole % to about 95 mole %, the mole % of repeat unit of structure (II) ranges from about 5 mole % to about 25 mole %, the mole % of repeat unit of structure (III) ranges from about 2 mole % to about 18 mole %, where the sum of the mole % of these repeat units either is less than 100 mole % if other different repeat units are present, or equals 100 mole % if only the repeat units of structures (I), (II) and (III) are present, and further where said random copolymer has a polydispersity ranging from about 1.25 to about 1.80 and has an Mw which ranges from about 30,000 to about 45,000 Daltons, and said random copolymer is free of reactive end groups comprising a benzylic alcohol comprising moiety. In another aspect of this embodiment said random copolymer consists essentially of repeat units of structure (I), (II) and (III). In yet another aspect of this embodiment said random copolymer consists of repeat units of structure (I), (II) and (III), where the sum of the mole % of repeat units (I), (II) and (III) equals 100 mole %.

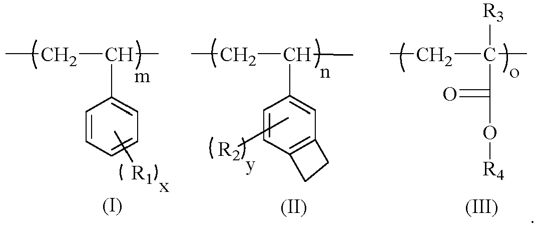

In another aspect of said random copolymer, the repeat unit of structure (III) ranges from about 2.5 mole % to about 20 mole %. In another aspect of this embodiment this repeat unit ranges from about 2.5 mole % to about 16 mole %. In another aspect of this embodiment this repeat unit ranges from about 3 mole % to about 15 mole %.

In another aspect of said random copolymer, the repeat unit of structure (II) ranges from about 6 mole % to about 23 mole %. In another aspect of this embodiment this repeat unit ranges from about 7 mole % to about 20 mole %. In another aspect of this embodiment this repeat unit ranges from about 7 mole % to about 15 mole %.

In another aspect of said random copolymer, the repeat unit of structure (I) ranges from about 62 mole % to about 93 mole %. In another aspect of this embodiment this repeat unit ranges from about 60 mole % to about 90 mole %.

In another aspect of said random copolymer, the repeat unit of structure (I) ranges from about 60 mole % to about 90 mole %, the repeat unit of structure (II) ranges from about 7 mole % to about 20 mole % and the repeat unit of structure (III) ranges from about 3 mole % to about 15 mole %.

In another aspect of said random copolymer, y is 0.

In another aspect of said random copolymer, x is 0.

In another aspect of said random copolymer, x and y are 0.

In another aspect of said random copolymer, R₃ is CH₃.

In another aspect of said random copolymer, R₄ is a C-2 to C-10 primary alkyl. In another aspect of this embodiment, R₄ is a C-2 to C-9 primary alkyl. In another aspect of this embodiment, R₄ is a C-2 to C-8 primary alkyl. In yet another aspect of this embodiment, R₄ is a C-2 to C-7 primary alkyl. In still another aspect of this embodiment R₄ is a C-3 to C-7 primary alkyl. In yet another aspect of this embodiment, R₄ is a C-3 to C-6 primary alkyl. In still another aspect of this embodiment, R₄ is a C-4 to C-6 primary alkyl. In still another aspect of this embodiment, R₄ is a C-4 to C-5 primary alkyl. In another aspect of this embodiment, R₄ is n-butyl.

In another aspect of said random copolymer, R₄ is a C-2 to C-6 primary alkyl. In another aspect of this embodiment R₄ is a C-2 to C-5 primary alkyl. In yet another aspect of this embodiment, R₄ is a C-2 to C-4 primary alkyl. In still another aspect of this embodiment, R₄ is a C-2 to C-3 primary alkyl. In another aspect R₄ is n-propyl. In in yet another aspect of this embodiment, R₄ is ethyl.

In another aspect of said random copolymer, R₄ is a moiety comprising an arene. In one aspect of this embodiment, R₄ is a benzylic moiety. In another aspect of this embodiment R₄ is benzyl.

In another aspect of said random copolymer, R₄ is a moiety comprising an arene. In one aspect of this embodiment, R₄ is a phenyl comprising moiety. In one aspect of this embodiment it is a substituted phenyl. In another aspect of this embodiment R₄ is phenyl.

In another aspect of said random copolymer, R₄ is a moiety comprising an arene. In one aspect of this embodiment R₄ is a biphenyl. In one aspect of this embodiment it is a substituted biphenyl moiety. In another it is an unsubstituted biphenyl. In yet another embodiment R₄ is [1.1'-biphenyl-4-yl}.

In another aspect of said random copolymer, the repeat units have structures (Ia), (IIa) and (IIIa), as follows:

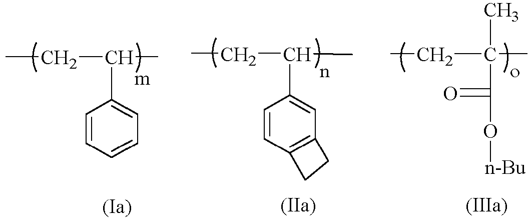

In another aspect of this embodiment, the repeat unit of structure (Ia) is present from about 60 mole % to about 90 mole %, the repeat unit of structure (IIa) is present from about 5 mole % to about 25 mole % and the repeat of structure (IIIa) is present from about 2 mole % to about 18 mole %.

In yet another aspect of this embodiment the repeat unit of structure (Ia) is present from about 75 mole % to about 90 mole %, the repeat unit of structure (IIa) is present from about 5 mole % to about 15 mole % and the repeat of structure (IIIa) is present from about 2 mole % to about 18 mole %.

In another aspect of said random copolymer, described herein, the repeat units have structures (Ia), (IIa) and (IIIa-1), as follows:

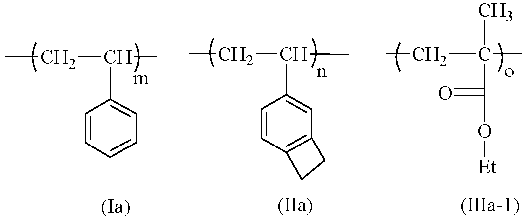

In another aspect of this embodiment the repeat unit of structure (Ia) is present from about 60 mole % to about 90 mole %, the repeat unit of structure (IIa) is present from about 5 mole % to about 25 mole % and the repeat of structure (IIIa-1) is present from about 2 mole % to about 18 mole %. In yet another aspect of this embodiment the repeat unit of structure (Ia) is present from about 60 mole % to about 90 mole %, the repeat unit of structure (IIa) is present from about 5 mole% to about 25 mole % and the repeat of structure (IIIa-1) is present from about 2 mole % to about 18 mole %.

In another aspect of said random copolymer, the repeat units have structures (Ia), (IIa) and (IIIb), as follows:

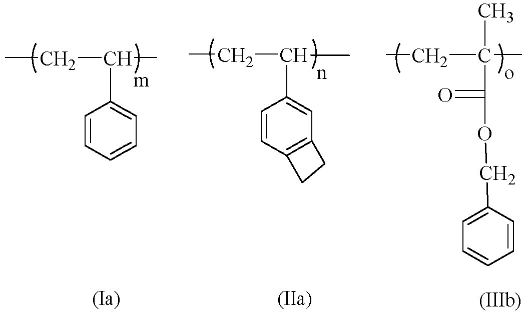

In another aspect of this embodiment the repeat unit of structure (Ia) is present from about 60 mole % to about 90 mole %, the repeat unit of structure (IIa) is present from about 5 mole % to about 25 mole % and the repeat of structure (IIIb) is present from about 2 mole % to about 18 mole %. In yet another aspect of this embodiment the repeat unit of structure (Ia) is present from about 65 mole % to about 85 mole %, the repeat unit of structure (IIa) is present from about 5 mole% to about 15 mole % and the repeat of structure (IIIb) is present from about 10 mole % to about 18 mole %.

In another aspect of said random copolymer, the repeat units have structures (Ia), (IIa) and (IIIc), as follow:

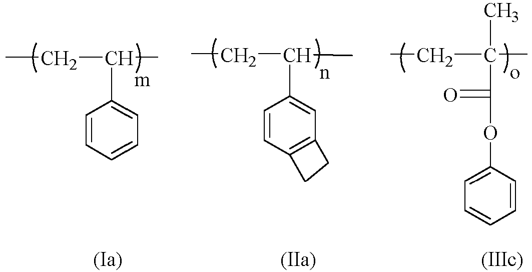

In another aspect of this embodiment the repeat unit of structure (Ia) is present from about 60 mole % to about 90 mole %, the repeat unit of structure (IIa) is present from about 5 mole % to about 25 mole % and the repeat of structure (IIIc) is present from about 2 mole % to about 18 mole %.

In yet another aspect of this embodiment the repeat unit of structure (Ia) is present from about 65 mole % to about 85 mole %, the repeat unit of structure (IIa) is present from about 5 mole % to about 15 mole% and the repeat of structure (IIIc) is present from about 10 mole % to about 18 mole %.

In another aspect of said random copolymer, described herein, the repeat units have structures (Ia), (IIa) and (IIId), as follows:

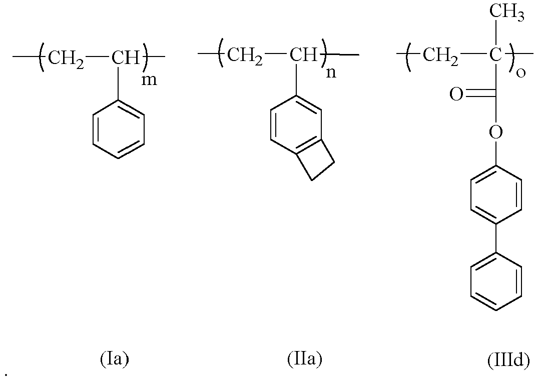

In another aspect of this embodiment the repeat unit of structure (Ia) is present from about 60 mole % to about 90 mole %, the repeat unit of structure (IIa) is present from about 5 mole % to about 25 mole% and the repeat of structure (IIId) is present from about 2 mole % to about 18 mole %. In yet another aspect of this embodiment the repeat unit of structure (Ia) is present from about 65 mole % to about 80 mole %, the repeat unit of structure (IIa) is present from about 5 mole % to about 15 mole% and the repeat of structure (IIId) is present from about 10 mole % to about 18 mole %.

Another aspect of this invention is a novel composition comprising said random copolymer and an organic spin casting solvent.

In another aspect, said novel composition comprises further additives as components such as surfactants, levelling agents, stabilizers, and the like. In one aspect of this embodiment it contains surfactants as additives to facilitate coating.

In another aspect of said novel composition, the organic spin casting solvent is one which can dissolve said random copolymers and any other additional optional components as noted above. This organic spin casting solvent may be a single solvent or a mixture of solvents. Suitable solvents are organic solvent which may include, for example, a glycol ether derivative such as ethyl cellosolve, methyl cellosolve, propylene glycol monomethyl ether (PGME), diethylene glycol monomethyl ether, diethylene glycol monoethyl ether, dipropylene glycol dimethyl ether, propylene glycol n-propyl ether, or diethylene glycol dimethyl ether; a glycol ether ester derivative such as ethyl cellosolve acetate, methyl cellosolve acetate, or propylene glycol monomethyl ether acetate (PGMEA); carboxylates such as ethyl acetate, n-butyl acetate and amyl acetate; carboxylates of di-basic acids such as diethyloxylate and diethylmalonate; dicarboxylates of glycols such as ethylene glycol diacetate and propylene glycol diacetate; and hydroxy carboxylates such as methyl lactate, ethyl lactate (EL), ethyl glycolate, and ethyl-3-hydroxy propionate; a ketone ester such as methyl pyruvate or ethyl pyruvate; an alkyloxycarboxylic acid ester such as methyl 3-methoxypropionate, ethyl 3-ethoxypropionate, ethyl 2-hydroxy-2-methylpropionate, or methylethoxypropionate; a ketone derivative such as methyl ethyl ketone, acetyl acetone, cyclopentanone, cyclohexanone or 2-heptanone; a ketone ether derivative such as diacetone alcohol methyl ether; a ketone alcohol derivative such as acetol or diacetone alcohol; a ketal or acetal like 1,3 dioxalane and diethoxypropane; lactones such as butyrolactone; an amide derivative such as dimethylacetamide or dimethylformamide, anisole, and mixtures thereof.

In another aspect of said novel composition, said random copolymer constitutes from about 0.1 wt% to about 2 wt% of the total weight of said composition including the organic spin casting solvent. In another aspect it constitutes from about 0.1 wt% to about 1 wt%. In yet another embodiment is constitutes from about 0.2 wt% to about 0.5 wt%. In yet another embodiment it constitutes from about 0.2 wt% to about 0.3 wt%.

Another aspect of this invention is a process of forming a crosslinked layer of a copolymer on a substrate using the novel composition described herein comprising the following steps:
a) forming a coating of the novel compositions described herein on a substrate;
b) heating the coating at a temperature ranging from about 90°C to about 180°C to remove solvent;
c) heating the coating at a temperature ranging from about 200°C to about 350°C to form a crosslinked copoylmer coating layer or a pinning MAT layer.

Another aspect of this invention which also employs the novel composition described herein, is a process of chemoepitaxy, directed self-assembly of a block copolymer layer used to form an image comprised of the following steps:
a-1) coating a substrate with a graftable neutral layer polymer precursor to form a coated layer 1;
b-1) heating coated layer 1 at a temperature from 90°C to 180°C to remove solvent;
c-1) heating the coated layer 1 after step b-1) at a temperature from about 200°C to about 350°C, preferably to about 330 °C, to affect grafting;
d-1) treating the coated layer 1 after step c-1) with an organic solvent to remove ungrafted neutral layer polymer, leaving an insoluble grafted neutral layer on the substrate;
e-1) coating a negative photoresist layer over the grafted neutral layer;
f-1) forming a negative pattern in the photoresist layer, thereby forming regions in which the grafted neutral layer is covered or uncovered by the photoresist, where the pattern in the photoresist is comprised of both small nanometer sized repeating patterns and also large areas of photoresist removed during the imaging process containing no repeating nanometer sized patterns;
g-1) etching to remove the neutral layer regions uncovered in step f-1) leaving bare substrate in these regions;
h-1) stripping the photoresist away from the substrate after step g-1), leaving a patterned substrate in which regions of substrate left uncovered by photoresist in step f-1) are free of a grafted neutral layer and the regions covered by photoresist in step f-1) retain the grafted neutral layer;
i-1) coating the patterned substrate the novel compositions described herein to form a coated layer 2;
j-1) heating the coated layer 2 a temperature of about 90°C to about 180°C to remove solvent;
k-1) heating the coating layer 2 at a temperature ranging from about 200°C to about 350°C, for about 1 to about 10 minutes, leaving an insoluble crosslinked pinning MAT layer on the substrate in the regions free of grafted neutral layer creating a substrate with both pinning MAT layer areas and neutral layer areas;
1-1) applying a coating of a block copolymer comprising an etch resistant styrenic block and a highly etchable aliphatic block over the substrate containing a patterned neutral layer and pinning MAT layer, creating a substrate containing both a patterned neutral layer and a patterned pinning MAT layer;
m-1) annealing the block copolymer layer until directed self-assembly occurs in the small nanometer sized repeating patterns of the substrate, but where no perpendicular orientation of block polymer domains occurs in the large areas containing pinning MAT layer;
o-1) etching the block copolymer, thereby removing the highly etchable block of the copolymer and forming a repeating nanometer sized pattern in the areas where directed self-assembly of the block copolymer occurred on the substrate in step m-1).

A process of chemoepitaxy, directed self-assembly of a block copolymer layer used to form an image which employs the novel composition described herein comprising the steps:
a-2) forming a coating of a neutral layer polymer precursor which is crosslinkable or which is both crosslinkable and graftable on a substrate;
b-2) heating the neutral polymer layer precursor coating which is crosslinkable or the precursor coating which is both crosslinkable and graftable at a temperature from 90°C to 180°C to remove solvent;
c-2) heating the neutral layer polymer precursor coating which is crosslinkable or the coating precursor coating which is both crosslinkable and graftable at a temperature from 200°C to 330°C to form a crosslinked neutral layer or a crosslinked and grafted neutral layer;
d-2) providing a coating of a negative photoresist layer over the crosslinked neutral layer or over the crosslinked and grafted neutral layer;
e-2) forming a negative pattern in the photoresist layer, thereby forming regions in which the crosslinked or the crosslinked and grafted neutral layer is covered or uncovered by the photoresist, where the pattern in the photoresist is comprised of both small nanometer repeating patterns and also large areas of photoresist removed during the imaging process containing no repeating nanometer sized patterns;
f-2) etching with a plasma to remove in the neutral layer regions uncovered in step e-2) removing crosslinked or crosslinked and grafted neutral layer leaving bare substrate in the regions uncovered in step e-2);
g-2) stripping the photoresist away from the substrate after step f-2), leaving a patterned substrate in which regions of substrate left uncovered by photoresist in step e-2) are free of a crosslinked or crosslinked and grafted neutral layer and the regions covered by photoresist in step f2) retain the crosslinked or crosslinked and grafted neutral layer;
h-2) coating the patterned substrate with the novel composition described herein to form a coated layer 3;
i-2) heating coated layer 3 at a temperature of about 90°C to about 180°C to remove solvent;
j-2) heating the coating layer 3 at a temperature ranging from about 200°C to about 350°C, preferably for about 1 to about 10 minutes, forming an insoluble crosslinked pinning MAT layer on the substrate in the regions free of grafted neutral layer, creating a substrate containing both pinning MAT layer areas and neutral layer areas;
k-2) applying a coating of a block copolymer comprising an etch resistant styrenic block and a highly etchable aliphatic block over the substrate containing a patterned neutral layer and pinning MAT layer;
l-2) annealing the block copolymer layer until directed self-assembly occurs in the small nanometer sized repeating patterns of the substrate, but where no perpendicular orientation of block polymer domains occurs in the large areas containing grafted pinning MAT layer;
m-2) etching the block copolymer, thereby removing the highly etchable block of the copolymer and forming a repeating nanometer sized pattern in the areas where directed self-assembly of the block copolymer occurred on the substrate in step 1-2).

A process of chemoepitaxy, directed self-assembly of a block copolymer layer used to form an image which employs the novel composition described herein comprising the steps:
a-3) forming a coating of the novel compositions described herein on a substrate forming a film,
b-3) baking said film at a temperature from about 200°C to about 350°C for about 1 to about 10 minutes forming an insoluble crosslinked pinning MAT layer,
c-3) providing a coating of a positive or negative photoresist layer over the crosslinked pinning MAT layer,
d-3) forming a negative or positive image respectively in the negative or positive photoresist layer, thereby forming regions in which the crosslinked pinning is covered or uncovered by the photoresist,
e-3) etching with a plasma to remove the crosslinked pinning MAT layer in the areas uncovered in step d-3) leaving bare substrate and leaving the crosslinked pinning MAT layer in the areas left covered in step d-3), forming a patterned crosslinked pinning MAT layer,
f-3) coating said patterned crosslinked pinning MAT layer with a neutral layer coating,
g-3) curing said neutral layer coating and washing away with a solvent uncured neutral layer forming in areas of said substrate not covered by said patterned crosslinked pinning MAT layer, a neutral directing layer forming on said substrate forming a chemoepitaxy directing layer,
h-3) coating on said chemoepitaxy directing layer a block copolymer solution forming a coating of block copolymer,
i-3) annealing said coating of block copolymer to form a directed self-assembled film of the block copolymer on said chemoepitaxy directing layer.
j-3) etching the block copolymer, thereby removing the highly etchable block of the copolymer and forming a repeating nanometer sized pattern in the areas where directed self-assembly of the block copolymer occurred on the substrate in step h-3).

In another aspect of the chemoepitaxy processes, described herein, comprising steps a-1) to o-1), a-2) to m-2), or a-3) to j-3) in the above pinning MAT layer baking process j-1), j-2), or b-3), the baking time in may be also be varied in one embodiment from about 2 min to about 7 min, in another embodiment from about 2 min to about 5 min.

In another aspect of the chemoepitaxy processes, said crosslinked pinning MAT layer in steps c), k-1), j-2) or b-3) have a thickness from about 5 nm to about 20 nm. In another aspect is has a thickens from about 7 nm to about 14 nm.

In another aspect of the chemoepitaxy processes comprising steps a-1) to o-1), a-2) to m-2), or a-3) to j-3), said substrate is one as described as suitable as later described herein. As one example a semiconductor substrate such as silicon may be employed. As another example the substrate is a metal. As a further example the substrate may be a metal oxide. In another example it may be SiN. In yet another example it may be an organic coating such as a bottom antireflective coating (BARC).

In another aspect of the chemoepitaxy processes comprising steps a-1) to o-1), a-2) to m-2), or a-3) to j-3), said block copolymer comprising an etch resistant styrenic block and a highly etchable aliphatic block is a block copolymer is one as described later herein. In one aspect of this embodiment it is a block copolymer of styrene and methyl methacrylate.

In another aspect of the chemoepitaxy processes comprising steps a-1) to o-1) a-2) to m-2), or a-3) to i-3), in steps m-1), 1-2) or i-3), respectively, the annealing of said coating of block copolymer may be done at a temperature of about 230°C to about 260°C for about 5 minutes to about 30 minutes.

In another aspect of the chemoepitaxy processes comprising steps a-1) to o-1), a-2) to m-2) or a-3) to j-3), the self-assembled bock copolymer domains are used to provide a selective barrier against etching into the substrate, this selectivity in etching may either be imparted by a differing reactivity of the assembled block domains towards a chemical etchant, or by a differing reactivity towards a plasma etching step, used to etch the substrate. One example is when one block is plasma etch resistant block and the other is highly etchable by the plasma. Selective etching into the substrate by the self-assembled block copolymer may be used to provide an image into the substrate. In turn this image may be used to in the manufacture of microelectronic devices by defining structures in specific layers employed in a process to make a memory or logic device.

In another aspect of the chemoepitaxy processes comprising steps a-3) to j-3), the patterned crosslinked pinning MAT layer in above steps c-3), negative or positive resists may be coated on said crosslinked pinning MAT layer, imaged and developed and the resultant patterned resist used as an etch barrier to created said patterned crosslinked pinning MAT layer.

In another aspect of the chemoepitaxy processes comprising steps a-1) to o-1), a-2) to m-2) or a-3) to j-3), the etching steps may be done, for instance, with a plasma, or by a chemical etching. For positive resist their tone is reversed to obtain a negative image instead of positive by using an organic solvent to develop instead of a TMAH-based developer. Also, the radiation used to form the photoresist pattern formed may be selected from e-beam, broadband, 193 nm immersion lithography, 13.5 nm, 193nm, 248 nm, 365 nm and 436 nm radiation.

Another aspect of this invention is the use of the copolymer as described above, or the composition described above, for coating a substrate, preferably in a chemoepitaxy process.

In general, but without being bound by theory, when the substrate has a favorable interfacial energy with one domain than the other of a lamellar forming di-block copolymer, the interaction between the substrate and favorable domain causes the lamellar to be oriented parallel to the substrate in the thin film instead of perpendicular orientation. This parallel morphology of thin film has three typical structures such as asymmetric, symmetric and, hole and island structure depending on the BCP film thickness and the interfacial energy between the BCP domains and ambient environment (e.g., air or N₂). On a substrate grafted with polystyrene (PS), coated with the BCP and annealed in an N₂ atmosphere, both the PS domain and PMMA domain have the same interfacial energy. Consequently, both PS and PMMA domains can be located in an orientation parallel to the substrate surface.

Specifically, in the large areas stripped of neutral layer in the above described processes, on which a layer of the novel copolymer is crosslinked on the bare substrate, this crosslinked layer produces a unexpectedly strong, dense and uniform pinning MAT layers which may be used to avoid defect formation in these large areas which would occur for a diblock lamellar forming block copolymer of a styrenic (or other etch resistant polymer block of similar polarity to the novel crosslinked layer formed from the novel copolymer described herein) and aliphatic block (or other etchable polymer block of different polarity than the styrenic block). The formation of such an unexpectedly strong pinning MAT layer produce a surface which is very favorable to a consistent parallel lamellar orientation of the block copolymer consistently over the entire large area with the crosslinked pinning MAT layer formed from the novel copolymers described herein. These parallel lamellar orientations give rise to a block copolymer coating which concomitant with its uniformity of orientation, during pattern etching, gives a consistent etching rate over the entire area. This uniformity of etching over large areas the block copolymer coating, prevents formation of defect areas of inconsistent etch rate. This would occur if the block copolymer coating, during self-assembly, formed self-assembled island or hole structures morphologies, which would otherwise occur at a substrate for a given coating of a lamellar forming di block copolymer, having a given Lo which would on a good pinning area form either asymmetric or symmetric structures having parallel lamellar orientations of the block copolymer domains. Thus, for the crosslinked pinning MAT layer formed from the novel styrenic polymers there is formation of an unexpectedly strong and uniform pinning MAT layer which leads in turn to a consistent formation of parallel lamellar formation over the entire large area which do not contain nanometer sized repeating patterns such as lines and spaces or trenches.

In the above described chemoepitaxy processes, using the novel composition described herein, the block copolymer for use in conjunction with the novel composition capable of forming a pinning MAT layer can be any block copolymers which can form domains through self-assembly. The microdomains are formed by blocks of the same type which tend to self-associate. Typically, block copolymer employed for this purpose are polymers in which the repeat units derived from monomers are arranged in blocks which are different compositionally, structurally or both, and are capable of phase separating and forming domains. The blocks have differing properties which can be used to remove one block while keeping the other block intact on the surface, thus providing a pattern on the surface. Thus, the block may be selectively removed by plasma etching, solvent etching, developer etching using aqueous alkaline solution, etc. In block copolymers based on organic monomers, one block can be made from polyolefinic monomers including polydienes, polyethers including poly(alkylene oxides) such as poly(ethylene oxide), poly(propylene oxide), poly(butylene oxide) or mixtures thereof; and, the other block can be made from different monomers including poly((meth)acrylates), polystyrenes, polyesters, polyorganosiloxanes, polyorganogermanes, and or mixtures thereof. These blocks in a polymer chain can each comprise one or more repeat units derived from monomers. Depending on the type of pattern needed and methods used different types of block copolymers may be used. For instance, these may comprise diblock copolymers, triblock copolymers, terpolymers, or multiblock copolymers. The blocks of these block copolymers may themselves be comprised of homopolymers or copolymers. Block copolymers of different types may also be employed for self-assembly, such as dendritic block copolymers, hyperbranched block copolymers, graft block copolymers, organic diblock copolymers, organic multiblock copolymers, linear block copolymers, star block copolymers amphiphilic inorganic block copolymers, amphiphilic organic block copolymers or a mixture consisting of at least block copolymers of different types.

The blocks of organic block copolymer may comprise repeat units derived from monomers such as C-2 to C-30 olefins, (meth)acrylate monomers derived from C-1 to C-30 alcohols, inorganic-containing monomers including those based on Si, Ge, Ti, Fe, Al. Monomers based on C-2 to C-30 olefins can make up a block of high etch resistance alone or do so in combination with one other olefinic monomer. Specific example of olefinic monomers of this type are ethylene, propylene, 1-butene, 1,3-butadiene, isoprene, dihydropyran, norbomene, maleic anhydride, styrene, 4-hydroxy styrene, 4-acetoxy styrene, 4-methylstyrene, alpha-methylstyrene or mixtures thereof. Examples of highly etchable units can be derived from (meth)acrylate monomers such as (meth)acrylate, methyl (meth)acrylate, ethyl (meth)acrylate, n-propyl (meth)acrylate, isopropyl (meth)acrylate, n-butyl (meth)acrylate, isobutyl (meth)acrylate, n-pentyl (meth)acrylate, isopentyl (meth)acrylate, neopentyl (meth)acrylate, n-hexyl (meth)acrylate, cyclohexyl (meth)acrylate, isobornyl (meth)acrylate, hydroxyethyl (meth)acrylate or mixtures thereof.

An illustrative example of a block copolymer containing one type of high etch resistant repeat unit would be a polystyrene block containing only repeat units derived from styrene and another type of highly etchable polymethylmethacrylate block containing only repeat units derived from methylmethacrylate. These together would form the block copolymer poly(styrene-b-methylmethacrylate), where b refers to block.

Non-limiting examples of block copolymers that are useful for chemoepitaxy processes described herein, containing areas of patterned neutral layer, and areas of the patterned novel crosslinked pinning MAT layers include poly(styrene-b-vinyl pyridine), poly(styrene-b-butadiene), poly(styrene-b-isoprene), poly(styrene-b-methyl methacrylate), poly(styrene-b-alkenyl aromatics), poly(isoprene-b-ethylene oxide), poly(styrene-b-(ethylene-propylene)), poly(ethylene oxide-b-caprolactone), poly(butadiene-b-ethylene oxide), poly(styrene-b-t-butyl (meth)acrylate), poly(methyl methacrylate-b-t-butyl methacrylate), poly(ethylene oxide-b-propylene oxide), poly(styrene-b-tetrahydrofuran), poly(styrene-b-isoprene-b-ethylene oxide), poly(styrene-b-dimethylsiloxane), poly(methyl methacrylate-b-dimethylsiloxane), or a combination comprising at least one of the above described block copolymers. All these polymeric materials share in common the presence of at least one block which is rich in repeat units resistant to etching techniques typically employed in manufacturing IC devices and at least one block which etches rapidly under these same conditions. This allows for the directed self-assembled polymer to pattern transfer onto the substrate to affect either pattern rectification or pattern multiplication.

In the chemoepitaxy processes described herein, suitable molecular weight properties for the block copolymer are a weight-averaged molecular weight (M_{w}) in the range of about 3,000 to about 500,000 g/mol and a number averaged molecular weight (Mₙ) of about 1,000 to about 60,000 and a polydispersity (M_{w}/Mₙ) of about 1.01 to about 6, or 1.01 to about 2 or 1.01 to about 1.5. Molecular weight, both M_{w} and Mₙ, can be determined by, for example, gel permeation chromatography using a universal calibration method, calibrated to polystyrene standards. This ensures that the polymer blocks have enough mobility to undergo self-assembly when applied to a given surface either spontaneously, or by using a purely thermal treatment, or through a thermal process which is assisted by the absorption of solvent vapor into the polymer framework to increase flow of segments enabling self-assembly to occur.

Solvents suitable for dissolving these block copolymers for forming a film can vary with the solubility requirements of the block copolymer. Examples of solvents for the block copolymer assembly include propylene glycol monomethyl ether acetate (PGMEA), ethoxyethyl propionate, anisole, ethyl lactate, 2-heptanone, cyclohexanone, amyl acetate, n-butyl acetate, methyl n-amyl ketone (MAK), gamma-butyrolactone (GBL), toluene, and the like as well as combinations thereof. In an embodiment, specifically useful casting solvents include propylene glycol monomethyl ether acetate (PGMEA), gamma-butyrolactone (GBL), or a combination of these solvents.

The block copolymer composition can comprise additional components and/or additives selected from the group of: inorganic-containing polymers; additives including small molecules, inorganic-containing molecules, surfactants, photoacid generators, thermal acid generators, quenchers, hardeners, cross-linkers, chain extenders, and the like; and combinations comprising at least one of the foregoing, wherein one or more of the additional components and/or additives co-assemble with the block copolymer to form the block copolymer assembly.

The block copolymer composition is applied on a patterned substrate containing areas of patterned neutral layer, and areas of the patterned novel copolymer pinning MAT layer are defined on a surface by conventional lithography as described above where the neutral layer surface is formed by a material as previously described and the pinning MAT layer is formed by composition containing the novel copolymers described herein. Upon application and solvent removal, the block copolymer then undergoes self-assembly directed by the specific pattern formed by conventional lithographic processing over the neutral layer through a patterned chemical difference of the substrate surface created by conventional lithographic process. Either pattern rectification maintaining the same resolution is achieved and/or pattern multiplication may also be achieved if multiple phase boundaries are formed between the features defined with conventional lithography, depending on the relative pitch of the pattern versus the microphase separation distance after standard IC processing to pattern transfer.

The application of the block copolymer by spinning techniques (including spin drying) can suffice to form the self-directed block copolymer assembly. Other methods of self-directed domain formation can occur during applying, baking, annealing, or during a combination of one or more of these operations. In this way, an oriented block copolymer assembly is prepared by the above method, having microphase-separated domains that comprise cylindrical microdomains oriented perpendicular to the neutral surface, or that comprise lamellar domains oriented perpendicular to the neutral surface. Generally, the microphase-separated domains are lamellar domains oriented perpendicular to the neutral surface, which provide parallel line/space patterns in the block copolymer assembly. The domains, so oriented, are desirably thermally stable under further processing conditions. Thus, after coating a layer of a block copolymer assembly including a useful diblock copolymer such as, for example, poly(styrene-b-methyl methacrylate), and optionally baking and/or annealing, the domains of the block copolymer will form on and remain perpendicular to the neutral surface to give highly resistant and highly etchable regions on the surface of the substrate which can be further pattern transferred in the substrate layers. The directed self-assembled block copolymer pattern is transferred into the underlying substrate using known techniques. In one example, wet or plasma etching can be used with optional UV exposure. Wet etching can be with acetic acid. Standard plasma etch process, such as a plasma comprising oxygen may be used; additionally, argon, carbon monoxide, carbon dioxide, CF₄, CHF₃ may be present in the plasma.

In the present invention, the initial negative or positive tone photoresist pattern used for forming the directed self-assembly pattern can be defined using either negative or positive photoresists, in negative tone development processes or positive tone development processes, and imageable using any conventional lithographic techniques, such as e-beam, ion beam, x-ray, EUV (13.5 nm), broadband, or UV (450 nm-10 nm) exposure, immersion lithography, etc. In one embodiment, the present invention is particularly useful for 193nm imagewise exposure using either dry lithography or immersion lithography. For 193 nm lithography a commercially available positive 193 nm photoresist can be employed such as the non-limiting example of AZ AX2110P (available from EMD Performance Materials Corp, Somerville, NJ), photoresist from Shin-Etsu Chemical Corp., JSR Micro from Japan Synthetic Rubber, and other photoresists available from Fujifilm, TOK, etc. These photoresists may be developed after exposure, and post exposure baked using an aqueous alkaline developer comprising tetramethylammonium hydroxide to give a positive tone pattern or developed using an organic solvent such as methyl n-amyl ketone (MAK), n-butyl acetate, anisole, etc. to give a negative tone pattern. Alternatively, also for 193 nm exposure, commercially available negative tone photoresists may be employed.

The substrate usable with the novel coating and chemoepitaxy process described herein are any required in the manufacture of an IC device. In one example, the substrate is a wafer coated with a layer of high carbon content organic layer with a coating of silicon or titanium containing ARC (high etch resistance to oxygen plasma) over it, which allows pattern transfer of the patterned block copolymer into these coatings. Suitable substrates include, without limitation, silicon, silicon substrate coated with a metal surface, copper coated silicon wafer, copper, aluminum, polymeric resins, silicon dioxide, metals, doped silicon dioxide, silicon nitride(SiN), silicon carbide, tantalum, polysilicon, ceramics, aluminum/copper mixtures, glass, coated glass; gallium arsenide and other such Group III/V compounds. These substrates may be coated with antireflective coating(s). The substrate may comprise any number of layers made from the materials described above.

For the present invention, a variety of processes involving pinned chemoepitaxy may be employed to achieve a directed self-assembly of the aforementioned block copolymer using along with the novel styrenic polymer composition known neutral layers as described in US8,835,581, US9,181,449, US9,093,263, US8691925, US20140335324A1, US2016-0122579A1 or US application No. 14/885,328. This pattern can then be further transferred into the substrate. In this manner, a variety of high-resolution features may be pattern transferred into the substrate achieving either pattern rectification, pattern multiplication or both.

As described more specifically in the Example Section, it was found that Prepattern design flexibility is enabled by composition comprising the novel random copolymers described herein when these are used as pinning underlayers in chemoepitaxy processes. Conventional pinning MAT layers containing high contents of non-polar aromatic hydrocarbon monomers have low etch rate that causes issues of residue during the prepattern generation in chemoepitaxy. The novel materials disclosed herein possibly eliminate residue due to its easy etch-ability resulting in uniform assembly of line and space CD of the block copolymer domains.

A crosslinkable polystyrene pinning MAT is used for developing prepattern for L/S DSA. Although patterning has been performed using copolymer consisting of styrene and vinylbenzocylobutene efficiently for LiNe flow process for DSA, the crosslinked underlayer is difficult to etch while trimming the pattern after resist patterning and after DSA pattern transfer. Due to its low etch rate of such a copolymer consist of fully hydrophobic styrenic repeat units makes patterning difficult and leads to poor topography. An alternative pinning material has been prepared by adding an acrylate monomer that leads to higher etch rates and improved topography. This novel material also leads to improved BCP structures with improved edge placement error and almost no CD difference between guided and non-guided lines.

### EXAMPLES

Lithographic Exposures were done with a ASML (ASML Veldhoven, De Run 65015504 DR, Veldhoven The Netherlands) NXT 1950i. Etching Experiments were done with a LAM (4650 Cushing Parkway Fremont, CA 94538 U.S.A.) Kiyo E5. Spinning and development of films and patterns was done with a SCREEN (SCREEN semiconductor solutions Co, Ltd. Tenjinkita-machi 1-1,Teranouchi-agaru 4-chome, Horikawa-dori, Kamigyo-ku, Kyoto, JAPAN), SOKUDO DUO track or a TEL(Tokyo Electrons Ltd., Akasaka Biz Tower 3-1 Akasaka 5-chome, Minato-ku, Tokyo 107-6325) ACT-12. Stripping of photo resist pattern was done with a SCREEN (SCREEN semiconductor solutions Co, Ltd. Tenjinkita-machi 1-1,Teranouchi-agaru 4-chome, Horikawa-dori, Kamigyo-ku, Kyoto, JAPAN ) AQUASPIN. Scanning Electron Micrographs were obtained with a Hitachi H-5000 (Hitachi High Technologies America Inc. 10 North Martingale Road, Suite 500 Schaumburg, Illinois 60173-2295).

### SYNTHESIS OF BLOCK COPOLYMER AND NEUTRAL BRUSH

### Neutral Underlayer Synthesis Example 1 Synthesis of P(S-co-PMMA) Brush Neutral layer Polymer

A 2000-ml flask equipped with a condenser, temperature controller, heating mantle and mechanical stirrer were set up. 400 g (3.84 moles) of styrene(S), 401 g (4 moles) of methyl methacrylate (MMA), 9.44 g (0.016 moles) of nitroxide initiator and 534 g of anisole were added to the flask. The mechanical stirrer was turned on and set up at about 120 rpm. The reaction solution was then degassed by vigorously bubbling nitrogen through the solution for about 30 minutes at room temperature. After 30 minutes of degassing the heating mantle was turned on and the temperature controller was set at 140 °C, and the stirred reaction mixture was maintained at this temperature for 20 hours. After this time the heating mantle was turned off and the reaction solution was allowed to cool down to about 40 °C. Then the reaction mixture was poured into 13 L of isopropanol stirred with a mechanical stirring during the addition. During this addition, the polymer was precipitated out. The precipitated polymer was collected by filtration. The collected polymer was dried in vacuum oven at 40 °C. About 500 grams of the polymer was obtained. This dried polymer was dissolved in 1500 g of THF and then filtered through a 0.2 um nylon filter. The filtered solution was then precipitated again into a stirred solution of 13 L methanol, the precipitated polymer collected and dried as before under vacuum at 40 °C. In this manner, 400 grams (48% yields) of the polymer was obtained after dry. The polymer had an M_{w} of about 15k and a polydispersity (PDI) of 1.5.

### Synthesis of Block Copolymer 1 Anionic copolymer of styrene and methyl methacrylate

P(S-b-MMA) (21K-b-24K) was synthesized using the same procedure as described in previous examples. Briefly, 20 g (0.192 moles) of styrene was polymerized with 0.68 mL (1.4M solution) of sec-butyllithium. Then 0.196 g (0.0011 moles) of 1,1'-diphenylethylene (DPE) in 2.5 mL of dry toluene was added via ampule into the reactor. The orange color of the reaction mixture turned into dark brick-red indicating conversion of styryllithium active centers to delocalized DPE adduct carbanion. After 2 min of stirring, a small amount (2 mL) of the reaction mixture was withdrawn for PS block molecular weight analysis. Then methyl methacrylate (22.85 g, 0.23 moles) was added via ampule. The reaction was terminated after 30 min with 1 mL of degassed methanol. The block copolymer was recovered by precipitation in excess isopropanol (5 times of the polymer solution) containing 10% water, filtered, and dried at 70°C for 12 h under vacuum giving 40 g of P(S-b-MMA) (94% yield).

### Comp. Ex. 1 Synthesis of Comparative Polymer 1, Copolymer of styrene and 4-vinylbenzocylobutene

660.3 g styrene (≥99%, stabilized with 4-tert-butylcatechol) was weighed into a 3L four-neck flask fitted on a heating mantle with a condenser, temperature controller and mechanical stirrer. 65 g vinylbenzocyclobutene (VBCB), 11.23 g azobisisobutyronitrile (AIBN) and 900 g 2-butanone (MEK) were added to the flask. The reaction solution was degassed by vigorously bubbling nitrogen through the solution for about 30 minutes at room temperature with mechanical stirring. The reaction was then heated to 80°C for 20 hours under nitrogen and then cooled to 40°C. The reaction mixture was then precipitated in isopropanol, filtered, and dried in a vacuum oven. Mw 18,500 g/mole, PD 1.8.

### SYNTHESIS OF NOVEL COPOLYMERS

The novel copolymers (Ex. 1 to Ex.13), were prepared in 60% to 70% yield by radically copolymerizing polystyrene and 4-vinylbenzocyclobutene (VBCB), and a polar methacrylate monomer, as described in Tables 1 and 2 which were more susceptible to plasma etching because of their higher oxygen atom content. However, further incorporation of these polar methacrylate monomers into these copolymers, decreases the hydrophobicity of the polymer, which led to decreased pinning strength. Tables 1 and 2 shows details on the characteristics of these new copolymers and the layers they form which had the best compromise between retention of desirable hydrophobicity and increased etch ability. For comparison, these Tables also shows that data for Comp. Ex. 1 which is a copolymer of styrene and 4-vinylbenzocyclobutene which has higher plasma etch resistance and decreased etch-ability because of it lack oxygen atom.

### Ex. 1 Synthesis of Copolymer 1

46.86 g styrene (≥99%, stabilized with 4-tert-butylcatechol) was weighed into a round-bottom flask with 4.56g vinylbenzocyclobutene (VBCB), and 2.13 g butyl methacrylate (99%, stabilized with monomethyl ether hydroquinone), 0.41 g azobisisobutyronitrile (AIBN) and 100 g anisole. The flask was closed with a three-way stopper, degassed briefly, and flushed with argon. The mixture was frozen under liquid nitrogen bath while under vacuum and thawed three times, to remove residual moisture and impurities. The reaction was then heated to 73°C for 18 hours under nitrogen. The reaction mixture was then precipitated in isopropanol, filtered, and dried in a vacuum oven overnight. See Table 1 for composition, molecular weight.

### Ex. 2 Synthesis of Copolymer 2

41.68 g styrene (≥99%, stabilized with 4-tert-butylcatechol) was weighed into a round-bottom flask with 6.51 g vinylbenzocyclobutene (VBCB), and 7.11 g butyl methacrylate (99%, stabilized with monomethyl ether hydroquinone), 0.41 g azobisisobutyronitrile (AIBN) and 100 g anisole. The flask was closed with a three-way stopper, degassed briefly, and flushed with argon. The mixture was frozen under liquid nitrogen bath while under vacuum and thawed three times, to remove residual moisture and impurities. The reaction was then heated to 73°C for 18 hours under nitrogen. The reaction mixture was then precipitated in isopropanol, filtered, and dried in a vacuum oven overnight.

### Ex. 3 Synthesis of Copolymer 3

40.62 g styrene (≥99%, stabilized with 4-tert-butylcatechol) was weighed into a round-bottom flask with 4.56 g vinylbenzocyclobutene (VBCB), and 10.66 g butyl methacrylate (99%, stabilized with monomethyl ether hydroquinone), 0.41 g azobisisobutyronitrile (AIBN) and 100 g anisole. The flask was closed with a three-way stopper, degassed briefly, and flushed with argon. The mixture was frozen under liquid nitrogen bath while under vacuum and thawed three times, to remove residual moisture and impurities. The reaction was then heated to 73°C for 18 hours under nitrogen. The reaction mixture was then precipitated in isopropanol, filtered, and dried in a vacuum oven overnight. See Table 1 for composition, molecular weight.

### Ex. 4 Synthesis of Copolymer 4

43.23 g styrene (≥99%, stabilized with 4-tert-butylcatechol) was weighed into a round-bottom flask with 4.56 g vinylbenzocyclobutene (VBCB), and 7.11g n-butyl methacrylate (99%, stabilized with monomethyl ether hydroquinone), 0.41 g azobisisobutyronitrile (AIBN) and 100.21g anisole. The flask was closed with a three-way stopper, degassed briefly, and flushed with argon. The mixture was frozen under liquid nitrogen bath while under vacuum and thawed three times, to remove residual moisture and impurities. The reaction was then heated to 73°C for 17 hours under nitrogen. The reaction mixture was then precipitated in isopropanol, filtered, and dried in a vacuum oven overnight. See Table 1 for composition, molecular weight.

### Ex. 5 Synthesis of Copolymer 5

39.07 g styrene (≥99%, stabilized with 4-tert-butylcatechol) was weighed into a round-bottom flask with 6.53 g vinylbenzocyclobutene (VBCB), and 10.65 g n-butyl methacrylate (99%, stabilized with monomethyl ether hydroquinone), 0.4 1g azobisisobutyronitrile (AIBN) and 100 g anisole. The flask was closed with a three-way stopper, degassed briefly, and flushed with argon. The mixture was frozen under liquid nitrogen bath while under vacuum and thawed three times, to remove residual moisture and impurities. The reaction was then heated to 73°C for 17 hours under nitrogen. The reaction mixture was then precipitated in isopropanol, filtered, and dried in a vacuum oven overnight. See Table 1 for composition, molecular weight.

### Ex. 6 Synthesis of Copolymer 6

36.50 g styrene (≥99%, stabilized with 4-tert-butylcatechol) was weighed into a round-bottom flask with 9.77 g vinylbenzocyclobutene (VBCB), and 10.67 g n-butyl methacrylate (99%, stabilized with monomethyl ether hydroquinone), 0.41 g azobisisobutyronitrile (AIBN) and 100 g anisole. The flask was closed with a three-way stopper, degassed briefly, and flushed with argon. The mixture was frozen under liquid nitrogen bath while under vacuum and thawed three times, to remove residual moisture and impurities. The reaction was then heated to 73°C for 17 hours under nitrogen. The reaction mixture was then precipitated in isopropanol, filtered, and dried in a vacuum oven overnight. See Table 1 for composition, molecular weight.

### Ex. 7 Synthesis of Copolymer 7

33.86 g styrene (≥99%, stabilized with 4-tert-butylcatechol) was weighed into a round-bottom flask with 13.08 g vinylbenzocyclobutene (VBCB), and 10.66 g n-butyl methacrylate (99%, stabilized with monomethyl ether hydroquinone), 0.41 g azobisisobutyronitrile (AIBN) and 100 g anisole. The flask was closed with a three-way stopper, degassed briefly, and flushed with argon. The mixture was frozen under liquid nitrogen bath while under vacuum and thawed three times, to remove residual moisture and impurities. The reaction was then heated to 73°C for 17 hours under nitrogen. The reaction mixture was then precipitated in isopropanol, filtered, and dried in a vacuum oven overnight. See Table 1 for composition, molecular weight.

### Ex. 8, Synthesis of Copolymer 8

46.87 g styrene (≥99%, stabilized with 4-tert-butylcatechol) was weighed into a round-bottom flask with 4.58 g vinylbenzocyclobutene (VBCB) and 2.66 g benzyl methacrylate (99%, stabilized with monomethyl ether hydroquinone), 0.41 g azobisisobutyronitrile (AIBN) and 101.21 g anisole. The flask was closed with a three-way stopper, degassed briefly, and flushed with argon. The mixture was frozen under liquid nitrogen bath while under vacuum and thawed three times, to remove residual moisture and impurities. The reaction was then heated to 73°C for 17 hours under nitrogen. The reaction mixture was then precipitated in isopropanol, filtered, and dried in a vacuum oven overnight. See Table 1 for composition, molecular weight.

### Ex. 9, Synthesis of Copolymer 9

43.24 g styrene (≥99%, stabilized with 4-tert-butylcatechol) was weighed into a round-bottom flask with 4.57 g vinylbenzocyclobutene (VBCB), and 8.83 g benzyl methacrylate (99%, stabilized with monomethyl ether hydroquinone), 0.41 g azobisisobutyronitrile (AIBN) and 102.21 g anisole. The flask was closed with a three-way stopper, degassed briefly, and flushed with argon. The mixture was frozen under liquid nitrogen bath while under vacuum and thawed three times, to remove residual moisture and impurities. The reaction was then heated to 73°C for 17 hours under nitrogen. The reaction mixture was then precipitated in isopropanol, filtered, and dried in a vacuum oven overnight. See Table 1 for composition, molecular weight.

### Ex. 10 Synthesis of Copolymer 10

40.63 g styrene (≥99%, stabilized with 4-tert-butylcatechol) was weighed into a round-bottom flask with 4.56 g vinylbenzocyclobutene (VBCB), and 13.22 g benzyl methacrylate (99%, stabilized with monomethyl ether hydroquinone), 0.41 g azobisisobutyronitrile (AIBN) and 101.25 g anisole. The flask was closed with a three-way stopper, degassed briefly, and flushed with argon. The mixture was frozen under liquid nitrogen bath while under vacuum and thawed three times, to remove residual moisture and impurities. The reaction was then heated to 73°C for 17 hours under nitrogen. The reaction mixture was then precipitated in isopropanol, filtered, and dried in a vacuum oven overnight. See Table 1 for composition, molecular weight.

### Ex. 11 Synthesis of Copolymer 11

40.62 g styrene (≥99%, stabilized with 4-tert-butylcatechol) was weighed into a round-bottom flask with 4.56 g vinylbenzocyclobutene (VBCB), and 10.66 g butyl methacrylate (99%, stabilized with monomethyl ether hydroquinone), 0.41 g azobisisobutyronitrile (AIBN) and 100 g anisole. The flask was closed with a three-way stopper, degassed briefly, and flushed with argon. The mixture was frozen under liquid nitrogen bath while under vacuum and thawed three times, to remove residual moisture and impurities. The reaction was then heated to 73°C for 18 hours under nitrogen. The reaction mixture was then precipitated in isopropanol, filtered, and dried in a vacuum oven overnight. See Table for composition, molecular weight.

### Ex. 12 Synthesis of Copolymer 12

41.68 g styrene (≥99%, stabilized with 4-tert-butylcatechol) was weighed into a round-bottom flask with 6.51 g vinylbenzocyclobutene (VBCB), and 5.71 g ethyl methacrylate (99%, stabilized with monomethyl ether hydroquinone), 0.41 g azobisisobutyronitrile (AIBN) and 100 g anisole. The flask was closed with a three-way stopper, degassed briefly, and flushed with argon. The mixture was frozen under liquid nitrogen bath while under vacuum and thawed three times, to remove residual moisture and impurities. The reaction was then heated to 73°C for 18 hours under nitrogen. The reaction mixture was then precipitated in isopropanol, filtered, and dried in a vacuum oven overnight. See Table for composition, molecular weight.

### Example 13 Synthesis of Copolymer 13

40.62 g styrene (≥99%, stabilized with 4-tert-butylcatechol) was weighed into a round-bottom flask with 4.56 g vinylbenzocyclobutene (VBCB), and 8.56 g ethyl methacrylate (99%, stabilized with monomethyl ether hydroquinone), 0.41 g azobisisobutyronitrile (AIBN) and 100 g anisole. The flask was closed with a three-way stopper, degassed briefly, and flushed with argon. The mixture was frozen under liquid nitrogen bath while under vacuum and thawed three times, to remove residual moisture and impurities. The reaction was then heated to 73°C for 18 hours under nitrogen. The reaction mixture was then precipitated in isopropanol, filtered, and dried in a vacuum oven overnight. See Table for composition, molecular weight.

**Table 1**

| **Polymer Name** | **Polymer Composition** | **Monomer ratio** | **Mw (kDa)** | **PDI** |
|---|---|---|---|---|
| Ex. 1 | P(S-VBCB-BuMA) | 90-7-3 | 36.2 | 1.32 |
| Ex.2 | P(S-VBCB-BuMA) | 80-10-10 | 38.9 | 1.45 |
| Ex. 3 | P(S-VBCB-BuMA) | 78-7-15 | 39.5 | 1.5 |
| Ex. 4 | P(S-VBCB-BuMA) | 83-7-10 | 37.6 | 1.52 |
| Ex. 5 | P(S-VBCB-BuMA) | 75-10-15 | 37.8 | 1.63 |
| Ex. 6 | P(S-VBCB-BuMA) | 70-15-15 | 39.4 | 1.59 |
| Ex. 7 | P(S-VBCB-BuMA) | 65-20-15 | 36.7 | 1.6 |
| Ex. 8 | P(S-VBCB-BnMA) | 90-7-3 | 34 | 1.7 |
| Ex. 9 | P(S-VBCB-BnMA) | 83-7-10 | 37 | 1.65 |
| Ex. 10 | P(S-VBCB-BnMA) | 78-7-15 | 40.7 | 1.64 |
| Ex. 11 | P(S-VBCB-EMA) | 90-7-3 | 33.4 | 1.65 |
| Ex. 12 | P(S-VBCB-EMA) | 80-10-10 | 34.3 | 1.59 |
| Ex. 13 | P(S-VBCB-EMA) | 78-7-15 | 38.5 | 1.6 |
| Comp. Ex. 1 | P(S-VBCB) | 93-7-0 | 18.7 | 2 |

### LITHOGRAPHIC AND CHEMOEPITAXY PROCESSING

FIG. 1 shows the processing employed in for the novel pinning MAT layer compositions described herein and also for the comparative the layer of comparative polymer 1. Specifically, this shows a LiNe flow DSA for line and space multiplication scheme. The conditions used for prepattern development and DSA were using a Substrate a 13 nm thick SiN 13nm on Silicon, and either the following crosslinkable pinning materials, Comp. Ex 1, and Ex. 1, Ex. 2, or Ex. 3 were coated at a film thicknesses of 8 nm and cured at 315°C for 5 min in N₂ forming a crosslinked pinning MAT layer. The lithographic processing of this pinning MAT layer was done employing AIM-5484 PTD photoresist (JSR Micro, Inc.1280 N. Mathilda Ave. Sunnyvale, CA 940890, coated at a film thickness of 95nm and exposed with an ASML 1970i (iArF scanner) forming a photoresist pattern which exposed the underlying crosslinked pinning MAT layer. The trim etch condition where employing N₂O₂ etch chemistry for plasma etch which removed the crosslinked pining material in the areas not covered by patterned photoresist.

### Formulation Preparation:

The dried copolymer prepared in the examples above (Ex. 1 to Ex 13), and Comp Ex. 1, Neutral Layer 1, Block Copolymer 1, were individually weighed in a vial and dissolved in PGMEA at 2 wt%. The vial was left on that shaker overnight and then filtered with PTFE syringe filter.

### Formulation Crosslinking to Form Pinning MAT Layers and Neutrality Evaluation:

The formulations containing the different copolymer (Ex. 1 to Ex. 13 and Comp Ex. 1), were individually coated on a Si wafers at a sufficient spin speed to obtain a film thickness around 8 nm. The wafer was then baked at 250°C for one hour under nitrogen and then rinsed for two minutes with EBR solvent to form the pinning MAT layers to be evaluated. The film thickness of these was measured by ellipsometry before and after EBR rinse to determine film loss.

To determine neutrality, the MAT pinning layers were evaluated by coating them with a neutral polymer formulation (Neutral Layer 1), after they coating of formulation containing Ex. 1 to Ex. 13 or Comp Ex. 1 formulation coating and 250°C bake, and baked at 250°C for 30 minutes under nitrogen then rinsed for 2 minutes with EBR solvent (AZ EBR solvent, EMD PM Branchburg, 70 Meister Ave, Somerville, NJ 08876), and baked at low temperature to dry. The film thickness was measured before and after coating with the Neutral Layer to determine the film growth, if any. The film was then coated with the formulation containing Block Copolymer 1, to form a 35 nm film which was then annealed at 250°C for 30 minutes under nitrogen. This film was then imaged by CDSEM to determine the structure of the BCP for neutrality evaluation. All polymers tested showed little to no alignment of the BCP film, indicating that the polymers were non-neutral.
- The stripping of the photoresist was done using Orgasolv STR 301 (BASF, 100 Park Avenue Florham Park, NJ 07932, USA). The resultant patterned crosslinked pinning MAT layer were then coated with the composition containing the neutral brush (**Neutral Brush 1**), and baked at an 250°C for 30 minutes, followed by a 30 minute rinse with RER 600 (RER 600, Fujifilm, 200 Summit Lake Drive Valhalla, NY 10595), forming a pattern containing both neutral layer regions and pinning MAT layer regions. This pattern was then coated with the composition containing block copolymer 1, baked at 250°C for x min to form a baked film having a thickness of 35 nm, and then annealed at a temperature of 250°C to affect directed self-assembly of the block copolymer domains.

Table 2 shows a comparison of the coatings obtained with the novel copolymers which incorporate between 3 and 15 mole% of polar methacrylate monomers. These properties include film thickness before and after rinse, k values at 193 nm, and WCA (water contact angle). This Table shows that the novel copolymers Ex. 1 to Ex. 13 all had WCA and k values similar to that of Comp. Ex. 1, the copolymer of styrene and 4-vinylbenzocylocbutene. This similarity was an indication that these materials would have pinning properties similar to Comp. Ex. 1 despite their significant oxygen content imparted by the incorporation of the polar methacrylate monomers which can facilitate plasma etching. Thus novel copolymer containing polar methacrylate monomer (Ex. 1 to Ex. 13), can be coated to form new hydrophobic crosslinkable underlayers pinning MAT materials for the polystyrene domains in PS-b-PMMA DSA because of the minimum change in water contact angle and k value shown in Table 2.

**Table 2**

| **Polymer Name** | **FT after bake** | **FT after rinse** | **k** | **WCA** |
|---|---|---|---|---|
| Ex. 1 | 7.79nm+0.63A | 7.64nm+0.36A | 0.8174 | 86.6 |
| Ex. 2 | 7.58nm+0.35A | 7.45nm+0.46A | 0.72524 | 85 |
| Ex. 3 | 8+0.1nm | 8+0.1nm | 0.7143 | 85+1.5 |
| Ex. 4 | 8+0.1nm | 8+0.2nm | 0.7563 | 86+0.9 |
| Ex. 5 | 7.8±0.1nm | 7.9±0.1nm | 0.698 | 84+0.3 |
| Ex.6 | 7.9±0.1nm | 7.9±0.1nm | 0.673 | 85+1.2 |
| Ex. 7 | 8.1±0.1nm | 8.1±0.2nm | 0.6553 | 85±1.2 |
| Ex. 8 | 7.7+0.1nm | 7.7±0.1nm | 0.84148 | 87+1.2 |
| Ex. 9 | 7.6+0.09nm | 7.6±0.1nm | 0.8209 | 85+0.9 |
| Ex. 10 | 7.4+0.1nm | 7.4±0.07nm | 0.8051 | 84+0.6 |
| Comp. Ex. 1 | 8.2+0.2nm | 8.2±0.1nm | 0.86042 | 87+0.3 |

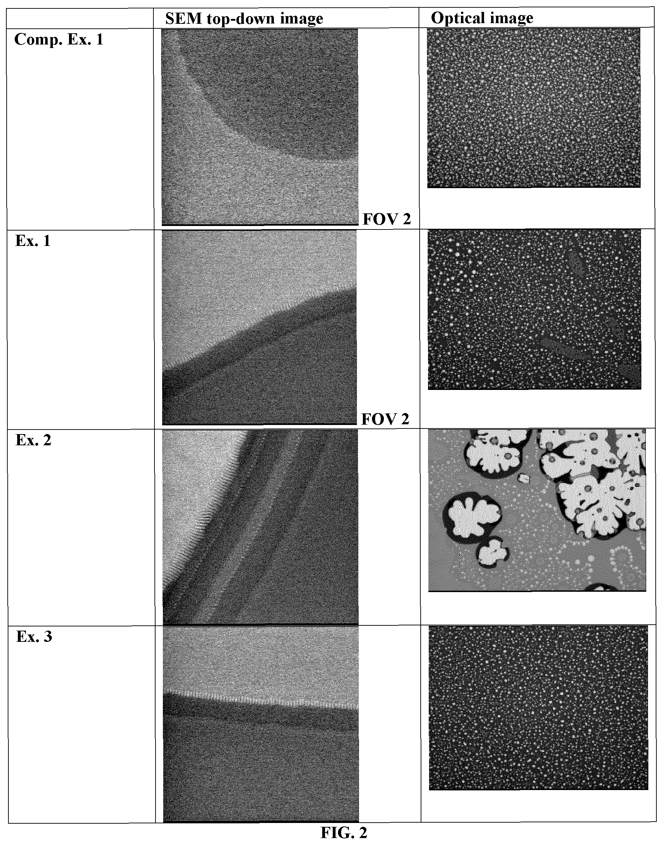

FIG. 2, Shows a comparison of a coating made from the reference, Comp Ex. 1, showing that this material has no neutrality towards a coating of a block polymer of styrene and methyl methacrylate (PS-b-PMMA) and new materials of Ex 1, 2, and 3 series (1 to 3 with different concentration of polar n-Butyl methacrylate monomer) showing similar behavior.

A 15 mole % addition of n-butyl methacrylate leads to a 10% increase in etch rate over what is observed for Comp Ex. 1 a copolymer of styrene and 4-vinylbenzocyclobutene. This results in a modified topography of the pinning stripe, with more vertical side walls as compared to the standard, thus smaller effect of the side walls on DSA performance. After N2/O₂ plasma etch for PMMA removal, the DSA process on the polymer with 15% n-BuMA addition shows minimal difference in size for guided versus unguided lines.

Trim etch or dry etch improved up to 4-15 % compared to the standard pining MAT layer derived from Com. Ex. 1.

Thus, a tunable dry etch resistance for pinning MAT layers has been achieved depending on the composition of polar comonomer in novel copolymer Ex 1 to Ex. 13.

### Reduction of polystyrene line CD more uniform with PMMA space CD across various litho pitches

### Ex. 1. Ex. 2, and Ex. 3. crosslinkability and non-neutrality check:

The copolymers were tested for crosslinkability using ~8 nm thin film and baked at 250°C for 30 mins under nitrogen. The film thickness was measured and the film was soak tested with PGMEA solvent. The results showed that these copolymers formed nice crosslinkable film and are stable even after soaking with PGMEA indicating crosslinking (Table 2).

Specifically, the crosslinkabilty soak tests for MAT pinning layers formed from the copolymers Ex. 1 to Ex. 10 or the formulation containing Comp. Ex. 1 were done by coating on Si and then baking (250°C/30min/N₂ 2 min), followed by a rinse with EBR 70/30.

After crosslinking these copolymers to form the MAT layers to be tested, a neutral underlayer (Neutral Layer 1, a hydroxyl terminal copolymer consisting of methyl methacrylate and styrene with PS 50 mol. %) was brushed via baking and rinsing. As the crosslinked MAT pinning layers, formed from copolymers Ex 1 to Ex 13, do not have any functional group for reaction with this brush neutral material, there will be no reaction and the MAT Pinning layer formed from formulation containing Ex. 1 to Ex. 13 it was expected that these surface should be free from any neutral grafts. This was verified by coating diblock copolymer and baked for development of any perpendicular morphology finger-print block copolymer domains. All these copolymers showed no figure print morphology rather they showed parallel morphology indicating the surface is hydrophobic that can selectively pin polystyrene domain of PS-b-PMMA diblock copolymer (FIG. 2).

### Etch Rate Comparison:

Polymers were dissolved in PGMEA and coated around 100nm on 8" Si wafers, soft baked at 110°C for one minute, and then annealed at 250°C for 30 minutes under nitrogen. The bulk etch rate of the polymer films was determined by O₂ (50 sccm) plasma etch for 0 to 60 seconds (in 10 second increments), with film thickness measurement determined by ellipsometry.

Table 3 shows a comparison of the normalized etch rates for the MAT pinning layers formed from formulations, containing polar methacrylate monomers Ex. 1 to Ex. 13, to the MAT pinning layer formed from the reference material Comp Ex. 1 which a copolymer of styrene and 4-vinylbenzocyclobutene with no polar methacrylate monomers.

These etch rates were determined by the slope of the of the graphed film thickness versus etch time, to give bulk etch rate in nm/s. The etch rate was then normalized by dividing by that of the reference material (Comp Ex. 1). The normalized etch rates are shown in Table 3.

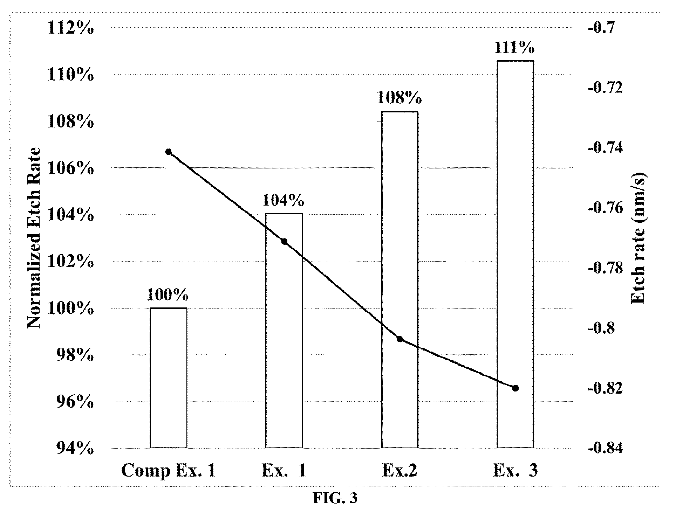

FIG. 3 shows an etch rate and normalized etch rate comparison between showing the bulk etch improvements of the Ex. 1 to Ex. 13 series compared to Comp Ex. 1. (Condition: ACT12: 110°C/1 min, 250°C/30 min (N₂). Trion Etcher: Pressure = 70 mT; Top/Bottom (W) = 50/50; O₂ (sccm) = 50.

As shown in FIG. 3, the etch rate increases with the addition of a polar component into the novel copolymers in the Ex 1. To Ex. 13 series. This is due to the increased rate of degradation of the polar moiety as compared to the aromatic during etch. The etch rate is further augmented by increasing the ratio of polar to nonpolar moiety in the polymer.

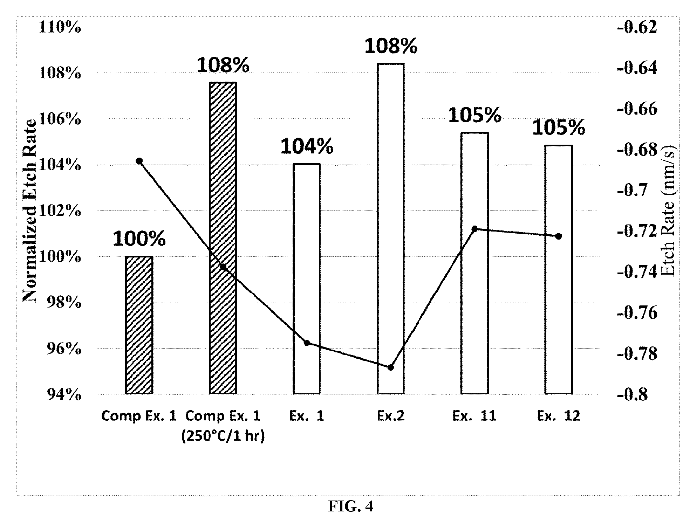

The Etch rate and Normalized etch rate comparison was also determined for the comparative samples after annealing at 250°C for 60 minutes under nitrogen as shown in FIG. 4. This showed a similar improvement in etch-ability compared to Comp Ex. 1 the copolymer of styrene and 4-vinylbenzocyclobutene. (Condition: ACT12: 110°C/1 min, 250°C/30 min (N₂). Trion Etcher: Pressure = 70 mT; Top/Bottom (W) = 50/50; O₂ (sccm) = 50).

FIG. 4 show etch rates of the reference material against the examples and comparative examples. As seen in the graph, the addition of the polar moiety increases the etch rate in comparison to the reference material, and the subsequent increase in the polar to nonpolar loading ratio further enhances this. However, the structure of the polar monomer has a significant effect on the etch rate. The addition of similar amounts of different polar compounds lead to very different etch rates, i.e. the etch rate comparison between Example 2 and Comparative Example 2. A summary of the normalized etch rates for each of the synthesized copolymers versus Comp Ex. 1 is shown in Table 1.

Table 3 shows the normalized etch rates novel copolymer Ex. 1, to Ex. 1, containing a polar methacrylate monomers compared to Comp Ex. 1 a copolymer of styrene and 4-vinylbenzocyclobutene.

**Table 3**

| Polymer Name | Polar Monomer | Mole % Polar Monomer | Normalized Etch Rate |
|---|---|---|---|
| Comp. Ex. 1 | none | 0 | 100% |
| Ex. 1 | nButyl methacrylate | 3 | 104% |
| Ex.2 | nButyl methacrylate | 10 | 108% |
| Ex. 3 | nButyl methacrylate | 15 | 111% |
| Ex. 4 | nButyl methacrylate | 10 | 104% |
| Ex. 5 | nButyl methacrylate | 15 | 108% |
| Ex. 6 | nButyl methacrylate | 15 | 104% |
| Ex. 7 | nButyl methacrylate | 15 | 103% |
| Ex. 8 | Benzyl methacrylate | 3 | 98% |
| Ex. 9 | Benzyl methacrylate | 10 | 99% |
| Ex. 10 | Benzyl methacrylate | 15 | 102% |
| Ex. 11 | Ethyl methacrylate | 3 | 105% |
| Ex. 12 | Ethyl methacrylate | 10 | 105% |

### DSA Process Window Evaluation:

The DSA process window was checked on patterned SiN wafer for evaluation of different pitch and etch dose combinations. The DSA prepatterns were prepared for DSA via lithography by the LiNe flow process as shown in FIG. 1. Briefly, SiN (13nm) was coated onto a Si wafer, then the crosslinkable PS mat was coated at 8 nm followed by a 315°C bake for 5 minutes under nitrogen. The guide-lines were formed using AIM-5484 PTD photoresist (95nm) imaged with an ASML 1970i, followed by N₂O₂ trim etch and stripping with STR Orgasolv and IPA rinse, resulting in a 90nm pitch guide pattern of the relevant xPS material. The formulation with Neutral Layer Polymer 1 (neutral brush) was coated onto the wafer, baked at 250°C for 30 minutes and the excess rinsed away with RER 600, resulting in a DSA chemical prepattern. The formulation containing Block Copolymer 1 (PS 43%, FT 35nm) was finally coated and annealed at 250°C for 5 or 30 minutes.

The critical dimension (CD) of the BCP lines formed was determined for after develop inspection (ADI), prior to etch, and after (AEI). The figure below shows the CD as it varies with dose (mJ/cm²) for Ex. 1, Ex 2. and Ex 3, which contain polar methacrylate monomers, against what was observed using Comp Ex. 1.) which does not contain a polar methacrylate monomer. The CD in each case is slightly larger for Ex. 3 than for the other materials.

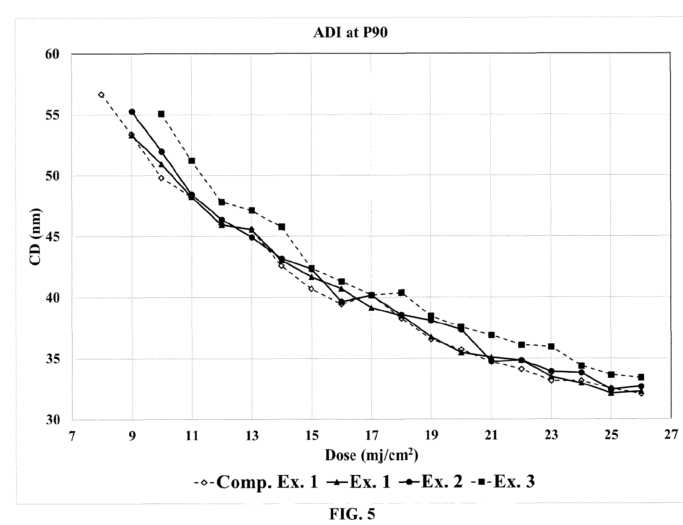

FIG. 5 compares the Lithographic performance of P90 nm. Ex. 3 induces larger ADI CD than other the other novel copolymer.

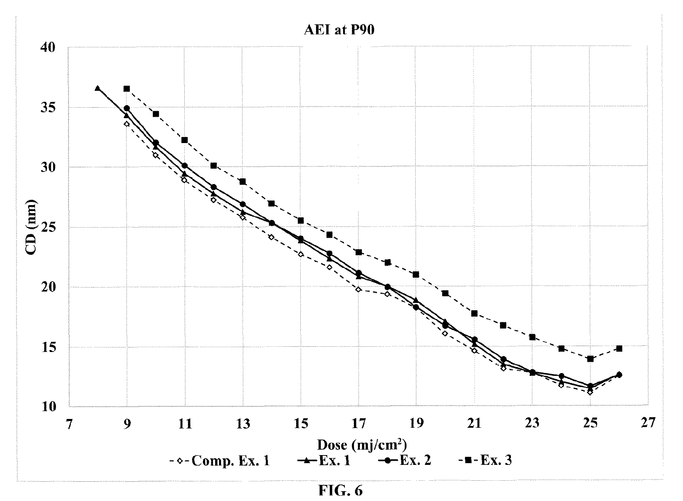

FIG. 6) compares the Lithographic performance on P90 nm and again shows that Ex. 3 induces larger after etch inspection (AEI) CD than other Ex. 1, Ex. 2, or Comp. Ex. 1.

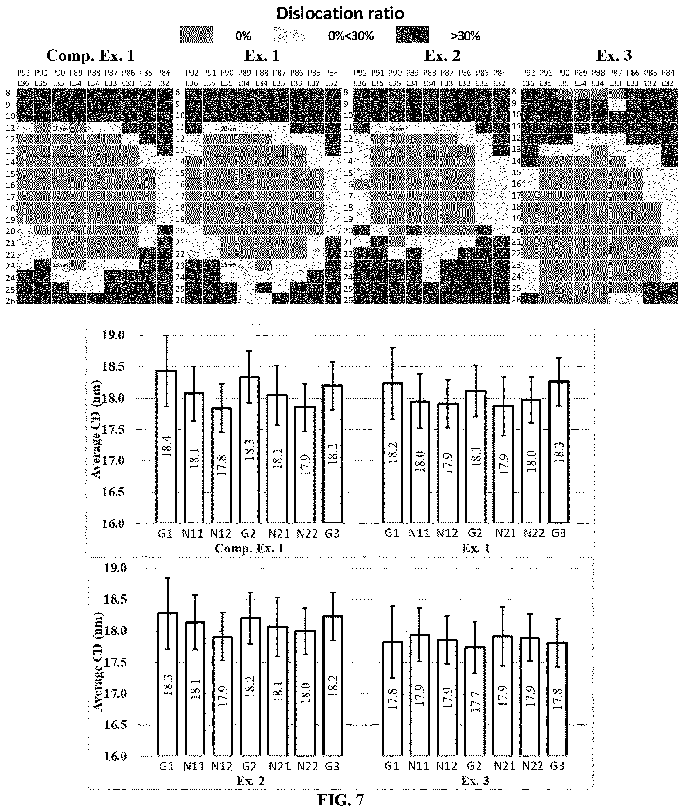

FIG. 7 shows the DSA process window of then novel pinning MAT pinning layers derived from Ex. 1, Ex. 2, and Ex 3. compared to the MAT pinning layer derived from Comp. Ex. 1. The DSA dislocation ratio was evaluated after N₂O₂ etch for PMMA removal. The process window was found to be of similar area for each of the materials, though slightly shifted for the formulation based on Ex 3. This meant that, despite the increase in polarity and hydrophilicity of the pinning material, the polymers are non-neutral and their pinning strength was sufficient to keep the DSA process window unaffected.

### DSA Critical Dimension (CD) Variation:

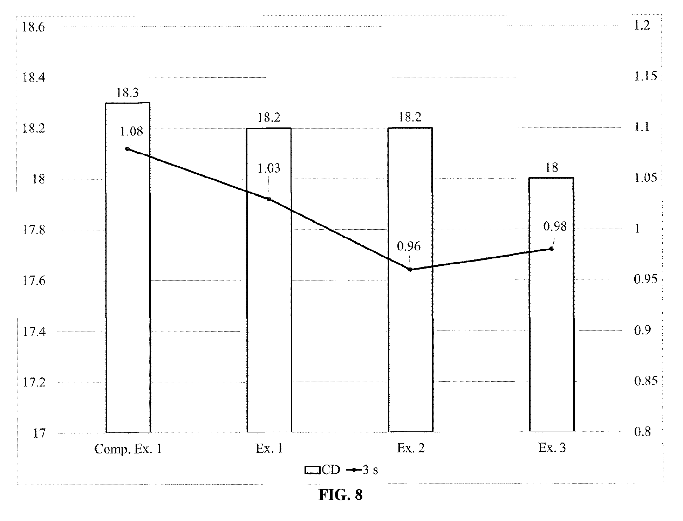

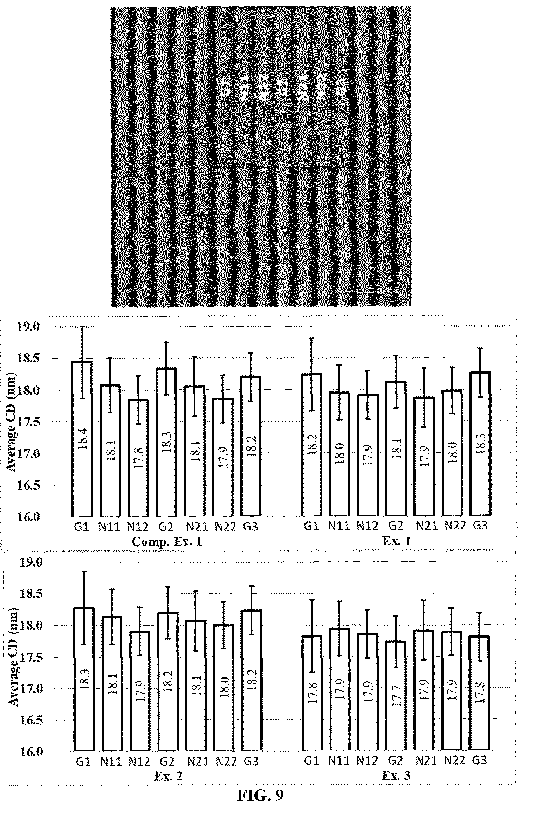

FIG. 8 shows the average CD and 3σ of DSA lines formed with Comp. Ex. 1 & Ex 1, Ex. 2 and Ex. 3. This shows that the DSA line width on guided (pinned) and non-guided (unpinned) areas was also compared. The line CD value was determined by averaging 10 lines each from 30 images. The image below shows the line CD and 3σ values from the images. No significant difference can be observed in CD with the different. FIG. 9 shows and an example of guided and unguided DSA lines formed and used in the above CD evaluation.

## Claims

1. A random copolymer whose repeat units comprise repeat units of structure (I), (II) and (III), wherein R₁ and R₂ are independently a C-1 to C-4 alkyl, x and y are independently the number of R₁ and R₂ which independently range from an integer from 0 to 3, R₃ is a C-1 to C-4 alkyl, and R₄ is selected from a C-2 to C-10 primary alkyl, or a moiety comprising an arene selected from the group consisting of a substituted or unsubstituted biphenyl moiety, a substituted or unsubstituted phenyl moiety, and a substituted or unsubstituted benzylic moiety and m, n, and o are respectively the number of repeat units of structures (I), (II) and (III), where the mole % of the repeat unit of structure (I) ranges from 60 mole % to 95 mole %, the mole % of repeat unit of structure (II) ranges from 5 mole % to 25 mole %, the mole % of repeat unit of structure (III) ranges from 2 mole % to 18 mole %, where the sum of the mole % of these repeat units either is less than 100 mole %, if other different repeat units are present, or equals 100 mole % if only the repeat units of structures (I), (II) and (III) are present, and further where said random copolymer has a polydispersity ranging from 1.25 to 1.80 and has an Mw, determined by gel permeation chromatography calibrated to polystyrene standards, which ranges from 30,000 to 45,000 daltons, and said random copolymer is free of reactive end groups comprising a benzylic alcohol comprising moiety,

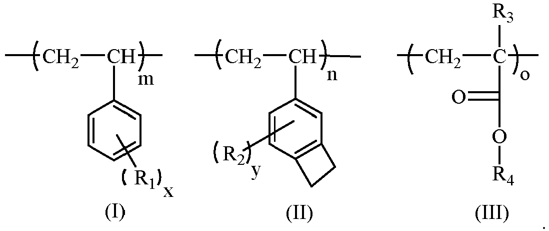

2. The random copolymer of claim 1, whose repeat units consist essentially of repeat units of structure (I), (II) and (III).

3. The random copolymer of claim 1 or 2, whose repeat units consist of repeat units of structure (I), (II) and (III), where the sum of the mole % of repeat units (I), (II) and (III) equals 100 mole %.

4. The random copolymer of any one of claims 1 to 3, wherein the repeat unit of structure (III) ranges from 2.5 mole % to 16 mole %, and/or the repeat unit of structures (II) ranges from 6 mole % to 23 mole %, and/or the repeat unit of structure (I) ranges from 62 mole % to 93 mole %.

5. The random copolymer of any one of claims 1 to 4, wherein the repeat unit of structure (I) ranges from 60 mole % to 90 mole %, the repeat unit of structure (II) ranges from 7 mole % to 20 mole% and the repeat unit of structure (III) ranges from 3 mole % to 15 mole%.

6. The random copolymer of any one of claims 1 to 5, wherein x is 0 or y is 0 or x and y are 0.

7. The random copolymer of any one of claims 1 to 6, wherein R₃ is CH₃.

8. The random copolymer of any one of claims 1 to 7, wherein R₄ is a C-3 to C-7 primary alkyl.

9. The random copolymer of any one of claims 1 to 8, wherein R₄ is a C-2 to C-6 primary alkyl.

10. The random copolymer of any one of claims 1 to 7, wherein R₄ is n-butyl, n-propyl, ethyl, or [1.1'-biphenyl-4-yl].

11. The random copolymer of any one of claims 1 to 7, wherein the repeat units have structures
(Ia), (IIa) and (IIIa); 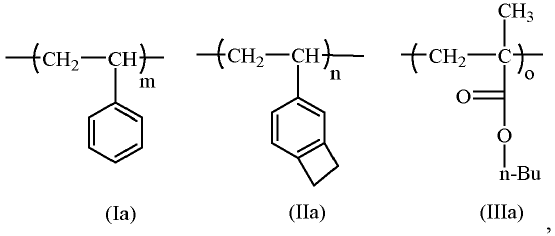 or
(Ia), (IIa) and (IIIa-1); 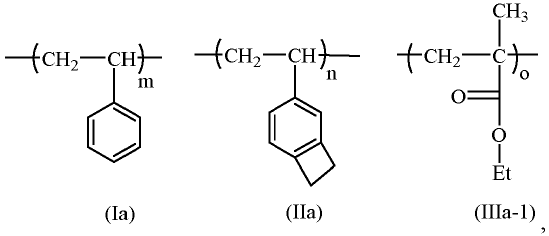 or
(Ia), (IIa) and (IIIb); 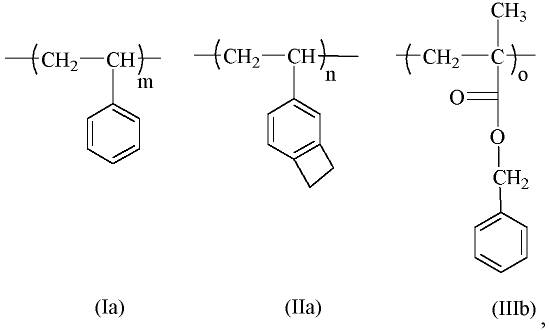 or
(Ia), (IIa) and (IIIc); 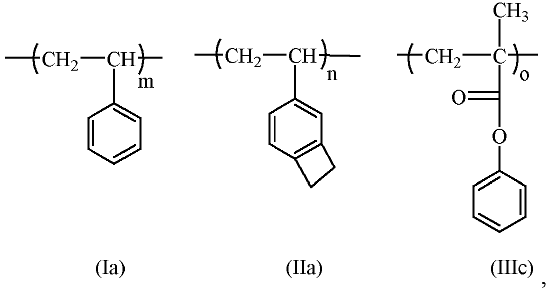 or
(Ia), (IIa) and (IIId);

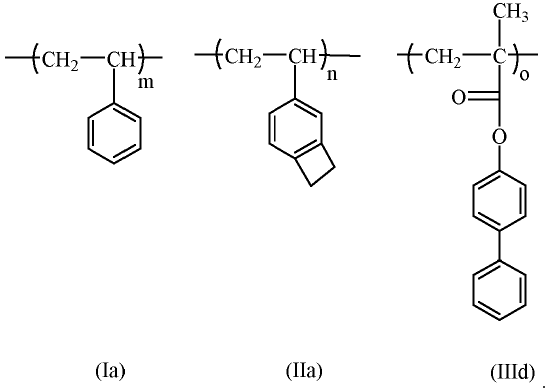

12. A composition comprising the random copolymer of any one of claims 1 to 11, and an organic spin casting solvent.

13. A process of forming a crosslinked layer of a copolymer on a substrate comprising the steps:
a) forming a coating of the composition of claim 12 on a substrate;
b) heating the coating at a temperature ranging from 90°C to 180°C to remove solvent;
c) heating the coating at a temperature ranging from 200°C to 350°C to form a crosslinked copolymer coating layer.

14. A process of chemoepitaxy, directed self-assembly of a block copolymer layer used to form an image comprised of the steps:
a-1) coating a substrate with a graftable neutral layer polymer precursor to form a coated layer 1;
b-1) heating coated layer 1 at a temperature from 90°C to 180°C to remove solvent;
c-1) heating the coated layer 1 after step b-1) at a temperature from 200°C to 350°C to affect grafting;
d-1) treating the coated layer 1 after step c-1) with an organic solvent to remove ungrafted neutral layer polymer, leaving an insoluble grafted neutral layer on the substrate;
e-1) coating a negative photoresist layer over the grafted neutral layer;
f-1) forming a negative pattern in the photoresist layer, thereby forming regions in which the grafted neutral layer is covered or uncovered by the photoresist, where the pattern in the photoresist is comprised of both small nanometer sized repeating patterns and also large areas of photoresist removed during the imaging process containing no repeating nanometer sized patterns;
g-1) etching to remove the neutral layer regions uncovered in step f-1) leaving bare substrate in these regions;
h-1) stripping the photoresist away from the substrate after step g-1), leaving a patterned substrate in which regions of substrate left uncovered by photoresist in step f-1) are free of a grafted neutral layer and the regions covered by photoresist in step f-1) retain the grafted neutral layer;
i-1) coating the patterned substrate with the composition of claim 12 to form a coated layer 2;
j-1) heating the coated layer 2 a temperature of 90°C to 180°C remove solvent;
k-1) heating the coating layer 2 at a temperature ranging from 200°C to 350°C, leaving an insoluble crosslinked pinning MAT layer on the substrate in the regions free of grafted neutral layer creating a substrate with both pinning MAT layer areas and neutral layer areas;
l-1) applying a coating of a block copolymer comprising an etch resistant styrenic block and a highly etchable aliphatic block over the substrate containing a patterned neutral layer and pinning MAT layer, creating a substrate containing both a patterned neutral layer and a patterned pinning MAT layer;
m-1) annealing the block copolymer layer until directed self-assembly occurs in the small nanometer sized repeating patterns of the substrate, but where no perpendicular orientation of block polymer domains occurs in the large areas containing crosslinked pinning MAT layer;
o-1) etching the block copolymer, thereby removing the highly etchable block of the copolymer and forming a repeating nanometer sized pattern in the areas where directed self-assembly of the block copolymer occurred on the substrate in step m-1).

15. A process of chemoepitaxy, directed self-assembly of a block copolymer layer used to form an image comprising the steps:
a-2) forming a coating of a neutral layer polymer precursor which is crosslinkable or which is both crosslinkable and graftable on a substrate;
b-2) heating the neutral polymer layer precursor coating which is crosslinkable or the precursor coating which is both crosslinkable and graftable at a temperature from 90°C to 180°C to remove solvent;
c-2) heating the neutral layer polymer precursor coating which is crosslinkable or the coating precursor coating which is both crosslinkable and graftable at a temperature from 200°C to 330°C to form a crosslinked neutral layer or a crosslinked and grafted neutral layer;
d-2) providing a coating of a photoresist layer over the crosslinked neutral layer or over the crosslinked and grafted neutral layer;
e-2) forming a negative pattern in the photoresist layer, thereby forming regions in which the crosslinked or the crosslinked and grafted neutral layer is covered or uncovered by the photoresist, where the pattern in the photoresist is comprised of both small nanometer repeating patterns and also large areas of photoresist removed during the imaging process containing no repeating nanometer sized patterns;
f-2) etching with a plasma to remove in the neutral layer regions uncovered in step e-2) removing crosslinked or crosslinked and grafted neutral layer leaving bare substrate in the regions uncovered in step e-2);
g-2) stripping the photoresist away from the substrate after step f-2), leaving a patterned substrate in which regions of substrate left uncovered by photoresist in step e-2) are free of a crosslinked or crosslinked and grafted neutral layer and the regions covered by photoresist in step f2) retain the crosslinked or crosslinked and grafted neutral layer;
h-2) coating the patterned substrate with the composition of claim 12 to form a coated layer 3;
i-2) heating coated layer 3 at a temperature of 90°C to 180°C to remove solvent;
j-2) heating the coating layer 3 at a temperature ranging from 200°C to 350°C, leaving an insoluble crosslinked pinning MAT layer on the substrate in the regions free of grafted neutral layer, creating a substrate containing both pinning MAT layer areas and neutral layer areas;
k-2) applying a coating of a block copolymer comprising an etch resistant styrenic block and a highly etchable aliphatic block over the substrate containing a patterned neutral layer and pinning MAT layer;
l-2) annealing the block copolymer layer until directed self-assembly occurs in the small nanometer sized repeating patterns of the substrate, but where no perpendicular orientation of block polymer domains occurs in the large areas containing crosslinked pinning MAT layer;
m-2) etching the block copolymer, thereby removing the highly etchable block of the copolymer and forming a repeating nanometer sized pattern in the areas where directed self-assembly of the block copolymer occurred on the substrate in step l-2).

16. A process of chemoepitaxy, directed self-assembly of a block copolymer layer used to form an image comprising the steps:
a-3) forming a coating of the composition of claim 12, on a substrate forming a film,
b-3) baking said film at a temperature from 200°C to 350°C for 1 to 10 minutes forming an insoluble crosslinked pinning MAT layer,
c-3) providing a coating of a positive or negative photoresist layer over the crosslinked pinning MAT layer,
d-3) forming a negative or positive image respectively in negative or positive photoresist layer, thereby forming regions in which the crosslinked pinning is covered or uncovered by the photoresist,
e-3) etching with a plasma to remove the crosslinked pinning MAT layer in the areas uncovered in step d-3) leaving bare substrate and leaving the crosslinked pinning MAT layer in the areas left covered in step d-3), forming a patterned crosslinked pinning MAT layer,
f-3) coating said patterned crosslinked pinning MAT layer with a neutral brush layer coating,
g-3) curing said neutral layer brush coating and washing away with a solvent ungrafted neutral layer forming in areas of said substrate not covered by said patterned crosslinked pinning MAT layer, a neutral brush directing layer forming on said substrate forming a chemoepitaxy directing layer,
h-3) coating on said chemoepitaxy directing layer a block copolymer solution forming a coating of block copolymer,
i-3) annealing said coating of block copolymer to form a directed self-assembled film of the block copolymer on said chemoepitaxy directing layer,
j-3) etching the block copolymer, thereby removing the highly etchable block of the copolymer and forming a repeating nanometer sized pattern in the areas where directed self-assembly of the block copolymer occurred on the substrate in step h-3).

17. The use of the copolymer according to any one of claims 1 to 11 or the composition according to claim 12, for coating a substrate, preferably in a chemoepitaxy process.

## Patentansprüche

1. Statistisches Copolymer, dessen Wiederholungseinheiten Wiederholungseinheiten der Struktur (I), (II) und (III) umfassen, wobei R₁ und R₂ unabhängig voneinander ein C-1- bis C-4-Alkyl sind, x und y unabhängig voneinander die Anzahl von R₁ und R₂ sind, die unabhängig voneinander im Bereich einer ganzen Zahl von 0 bis 3 liegen, R₃ ein C-1- bis C-4-Alkyl ist und R₄ aus einem primären C-2- bis C-10-Alkyl, oder einer Einheit ausgewählt ist, die ein Aren umfaßt ausgewählt aus der Gruppe bestehend aus einer substituierten oder unsubstituierten Biphenyleinheit, einer substituierten oder unsubstituierten Phenyleinheit und einer substituierten oder unsubstituierten Benzyleinheit, und m, n und o jeweils die Anzahl der Wiederholungseinheiten der Strukturen (I), (II) und (III) sind, wobei die Mol-% der Wiederholungseinheit der Struktur (I) im Bereich von 60 Mol-% bis 95 Mol-% liegen, die Mol-% der Wiederholungseinheit der Struktur (II) im Bereich von 5 Mol-% bis 25 Mol-% liegen, die Mol-% der Wiederholungseinheit der Struktur (III) im Bereich von 2 Mol-% bis 18 Mol-% liegen, wobei die Summe der Mol-% dieser Wiederholungseinheiten entweder weniger als 100 Mol-% beträgt, wenn andere unterschiedliche Wiederholungseinheiten vorhanden sind, oder gleich 100 Mol-% ist, wenn nur die Wiederholungseinheiten der Strukturen (I), (II) und (III) vorhanden sind, und wobei ferner das statistische Copolymer eine Polydispersität im Bereich von 1,25 bis 1,80 aufweist und ein Mw, bestimmt durch Gelpermeationschromatographie, kalibriert auf Polystyrolstandards, aufweist, das im Bereich von 30.000 bis 45.000 Dalton liegt, und das statistische Copolymer frei von reaktiven Endgruppen ist, die eine Benzylalkohol umfassende Einheit umfassen,

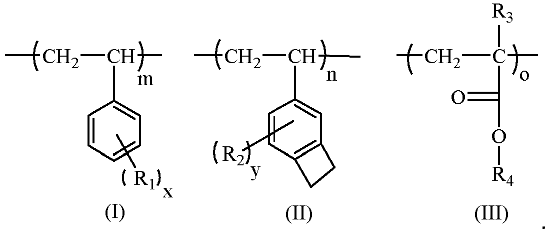

2. Statistisches Copolymer nach Anspruch 1, dessen Wiederholungseinheiten im Wesentlichen aus Wiederholungseinheiten der Struktur (I), (II) und (III) bestehen.

3. Statistisches Copolymer nach Anspruch 1 oder 2, dessen Wiederholungseinheiten aus Wiederholungseinheiten der Struktur (I), (II) und (III) bestehen, wobei die Summe der Mol-% der Wiederholungseinheiten (I), (II) und (III) gleich 100 Mol-% ist.

4. Statistisches Copolymer nach einem beliebigen der Ansprüche 1 bis 3, wobei die Wiederholungseinheit der Struktur (III) im Bereich von 2,5 Mol-% bis 16 Mol-% liegt und/oder die Wiederholungseinheit der Strukturen (II) im Bereich von 6 Mol-% bis 23 Mol-% liegt und/oder die Wiederholungseinheit der Struktur (I) im Bereich von 62 Mol-% bis 93 Mol-% liegt.

5. Statistisches Copolymer nach einem beliebigen der Ansprüche 1 bis 4, wobei die Wiederholungseinheit der Struktur (I) im Bereich von 60 Mol-% bis 90 Mol-%, die Wiederholungseinheit der Struktur (II) im Bereich von 7 Mol-% bis 20 Mol-% und die Wiederholungseinheit der Struktur (III) im Bereich von 3 Mol-% bis 15 Mol-% liegt.

6. Statistisches Copolymer nach einem beliebigen der Ansprüche 1 bis 5, wobei x gleich 0 oder y gleich 0 oder x und y gleich 0 sind.

7. Statistisches Copolymer nach einem beliebigen der Ansprüche 1 bis 6, wobei R₃ CH₃ ist.

8. Statistisches Copolymer nach einem beliebigen der Ansprüche 1 bis 7, wobei R₄ ein primäres C-3- bis C-7-Alkyl ist.

9. Statistisches Copolymer nach einem beliebigen der Ansprüche 1 bis 8, wobei R₄ ein primäres C-2- bis C-6-Alkyl ist.

10. Statistisches Copolymer nach einem beliebigen der Ansprüche 1 bis 7, wobei R₄ n-Butyl, n-Propyl, Ethyl oder [1.1'-Biphenyl-4-yl] ist.

11. Statistisches Copolymer nach einem der Ansprüche 1 bis 7, wobei die Wiederholungseinheiten die Strukturen (la), (IIa) und (IIIa); 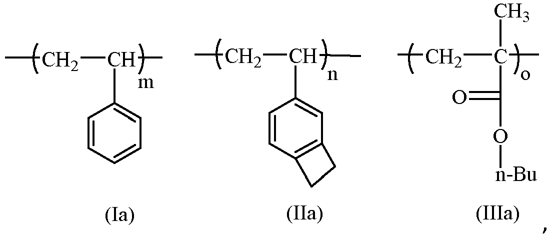 oder
(Ia), (IIa) **und** (IIIa-1); 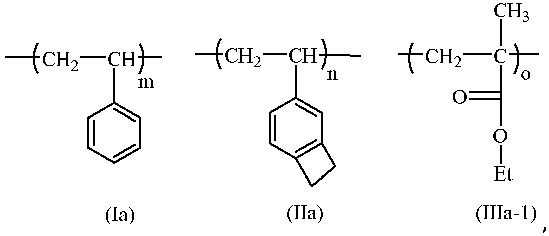 oder
(Ia), (IIa) **und** (IIIb); 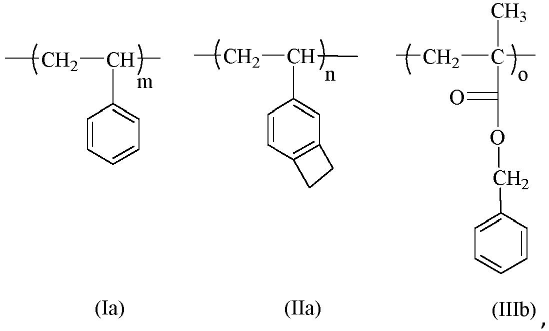 oder
(Ia), (IIa) **und** (IIIc); 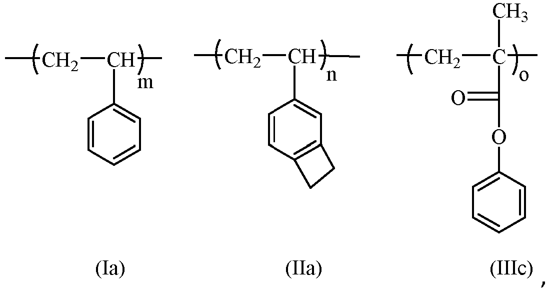 oder
(Ia), (IIa) und (IIId); 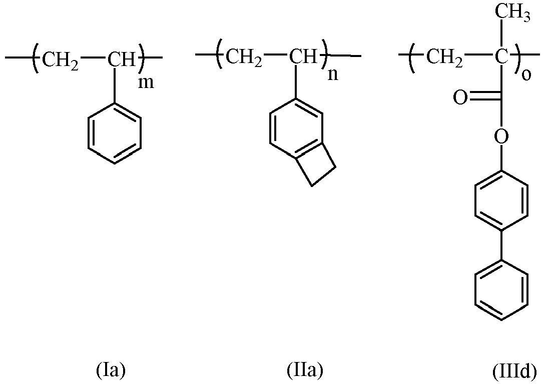 aufweisen.

12. Zusammensetzung, umfassend das statistische Copolymer nach einem beliebigen der Ansprüche 1 bis 11 und ein organisches Schleuderguss-Lösungsmittel.

13. Verfahren zur Bildung einer vernetzten Schicht eines Copolymers auf einem Substrat, umfassend die Schritte:
a) Ausbilden einer Beschichtung aus der Zusammensetzung nach Anspruch 12 auf einem Substrat;
b) Erhitzen der Beschichtung auf eine Temperatur im Bereich von 90°C bis 180°C, um das Lösungsmittel zu entfernen;
c) Erhitzen der Beschichtung auf eine Temperatur im Bereich von 200°C bis 350°C, um eine vernetzte Copolymer-Beschichtungsschicht zu bilden.

14. Verfahren der Chemoepitaxie, der gerichteten Selbstanordnung einer Blockcopolymerschicht, die zur Herstellung eines Bildes verwendet wird, umfassend die Schritte:
a-1) Beschichten eines Substrats mit einem pfropfbaren Neutralschicht-Polymervorläufer, um eine beschichtete Schicht 1 zu bilden;
b-1) Erhitzen der beschichteten Schicht 1 auf eine Temperatur von 90°C bis 180°C, um Lösungsmittel zu entfernen;
c-1) Erhitzen der beschichteten Schicht 1 nach Schritt b-1) auf eine Temperatur von 200°C bis 350°C, um Pfropfung zu bewirken;
d-1) Behandeln der beschichteten Schicht 1 nach Schritt c-1) mit einem organischen Lösungsmittel, um ungepfropftes Neutralschicht-Polymer zu entfernen, wobei eine unlösliche gepfropfte Neutralschicht auf dem Substrat zurückbleibt;
e-1) Auftragen einer negativen Photoresistschicht auf die gepfropfte Neutralschicht;
f-1) Bilden eines negativen Musters in der Photoresistschicht, wodurch Bereiche gebildet werden, in denen die gepfropfte Neutralschicht durch den Photoresist bedeckt oder unbedeckt ist, wobei das Muster in dem Photoresist sowohl kleine, nanometergroße, sich wiederholende Muster als auch aus große Bereiche des Photoresists umfasst, die während des Abbildungsprozesses entfernt wurden und keine sich wiederholenden nanometergroßen Muster enthalten;
g-1) Ätzen, um die in Schritt f-1) freigelegten neutralen Schichtbereiche zu entfernen, wobei in diesen Bereichen ein blankes Substrat zurückbleibt;
h-1) Ablösen des Photoresists vom Substrat nach Schritt g-1), wobei ein gemustertes Substrat zurückbleibt, bei dem die in Schritt f-1) von Photoresist unbedeckten Bereiche des Substrats frei von einer aufgepfropften Neutralschicht sind und die in Schritt f-1) von Photoresist bedeckten Bereiche die aufgepfropfte Neutralschicht beibehalten;
i-1) Beschichten des gemusterten Substrats mit der Zusammensetzung nach Anspruch 12, um eine beschichtete Schicht 2 zu bilden;
j-1) Erhitzen der beschichteten Schicht 2 auf eine Temperatur von 90°C bis 180°C, um das Lösungsmittel zu entfernen;
k-1) Erhitzen der Beschichtungsschicht 2 auf eine Temperatur im Bereich von 200°C bis 350°C, wobei eine unlösliche vernetzte Pinning-MAT-Schicht auf dem Substrat in den Bereichen ohne gepfropfte Neutralschicht zurückbleibt, wodurch ein Substrat mit sowohl Pinning-MAT-Schichtbereichen als auch Neutralschichtbereichen entsteht;
l-1) Aufbringen einer Beschichtung aus einem Blockcopolymer, das einen ätzresistenten Styrolblock und einen hoch ätzbaren aliphatischen Block umfasst, auf das Substrat, das eine gemusterte Neutralschicht und eine Pinning-MAT-Schicht enthält, wodurch ein Substrat entsteht, das sowohl eine gemusterte Neutraleschicht als auch eine gemusterte Pinning-MAT-Schicht enthält;
m-1) Tempern der Blockcopolymer-Schicht, bis eine gerichtete Selbstanordnung in den kleinen, nanometergroßen, sich wiederholenden Mustern des Substrats auftritt, wobei jedoch keine senkrechte Ausrichtung der Block-Polymer-Domänen in den großen Bereichen auftritt, die eine vernetzte Pinning-MAT-Schicht enthalten;
o-1) Ätzen des Blockcopolymers, wodurch der stark ätzbare Block des Copolymers entfernt wird und ein sich wiederholendes Muster in Nanometergröße in den Bereichen gebildet wird, in denen eine gerichtete Selbstanordnung des Blockcopolymers auf dem Substrat in Schritt m-1) auftrat.

15. Verfahren der Chemoepitaxie, der gerichteten Selbstanordnung einer Blockcopolymerschicht, die zur Herstellung eines Bildes verwendet wird, umfassend die Schritte:
a-2) Bildung einer Beschichtung aus einem neutralen Polymervorläufer, der vernetzbar ist oder der sowohl vernetzbar als auch pfropfbar ist, auf einem Substrat;
b-2) Erhitzen der Beschichtung aus dem neutralen Polymerschicht-Vorläufer, die vernetzbar ist, oder der Vorläuferbeschichtung, die sowohl vernetzbar als auch pfropfbar ist, auf eine Temperatur von 90°C bis 180°C, um Lösungsmittel zu entfernen;
c-2) Erhitzen der Neutralschicht-Polymervorläuferbeschichtung, die vernetzbar ist, oder der Beschichtungsvorläuferbeschichtung, die sowohl vernetzbar als auch pfropfbar ist, auf eine Temperatur von 200°C bis 330°C, um eine vernetzte Neutralschicht oder eine vernetzte und gepfropfte Neutralschicht zu bilden;
d-2) Bereitstellen einer Beschichtung aus einer Photoresistschicht über der vernetzten Neutralschicht oder über der vernetzten und gepfropften Neutralschicht;
e-2) Bilden eines negativen Musters in der Photoresistschicht, wodurch Bereiche gebildet werden, in denen die vernetzte oder die vernetzte und gepfropfte Neutralschicht von dem Photoresist bedeckt oder unbedeckt ist, wobei das Muster in dem Photoresist sowohl aus kleinen, sich wiederholenden Nanometer-Mustern als auch aus großen Bereichen des Photoresists besteht, die während des Abbildungsprozesses entfernt wurden und keine sich wiederholenden Muster in Nanometergröße enthalten;
f-2) Ätzen mit einem Plasma, um in der neutralen Schicht Bereiche zu entfernen, die in Schritt e-2) unbedeckt geblieben sind, wobei die vernetzte oder vernetzte und gepfropfte Neutralschicht entfernt wird und das blanke Substrat in den in Schritt e-2) unbedeckten Bereichen zurückbleibt;
g-2) Ablösen des Photoresists von dem Substrat nach Schritt f-2), wobei ein gemustertes Substrat zurückbleibt, in dem Bereiche des Substrats, die durch den Photoresist in Schritt e-2) unbedeckt geblieben sind, frei von einer vernetzten oder vernetzten und gepfropften Neutralschicht sind und die Bereiche, die durch den Photoresist in Schritt f-2) bedeckt sind, die vernetzte oder vernetzte und gepfropfte Neutralschicht beibehalten;
h-2) Beschichten des gemusterten Substrats mit der Zusammensetzung nach Anspruch 12 zur Bildung einer beschichteten Schicht 3;
i-2) Erhitzen der beschichteten Schicht 3 auf eine Temperatur von 90°C bis 180°C, um das Lösungsmittel zu entfernen;
j-2) Erhitzen der Beschichtungsschicht 3 auf eine Temperatur im Bereich von 200°C bis 350°C, wobei eine unlösliche vernetzte Pinning-MAT-Schicht auf dem Substrat in den Bereichen ohne gepfropfte Neutralschicht zurückbleibt, wodurch ein Substrat entsteht, das sowohl Pinning-MAT-Schichtbereiche als auch Neutralschichtbereiche enthält;
k-2) Aufbringen einer Beschichtung aus einem Blockcopolymer, das einen ätzresistenten Styrolblock und einen hoch ätzbaren aliphatischen Block umfasst, auf das Substrat, das eine gemusterte Neutralschicht und eine Pinning-MAT-Schicht enthält;
l-2) Tempern der Blockcopolymer-Schicht, bis eine gerichtete Selbstanordnung in den kleinen, nanometergroßen, sich wiederholenden Mustern des Substrats auftritt, wobei jedoch in den großen Bereichen, die eine vernetzte Pinning-MAT-Schicht enthalten, keine senkrechte Ausrichtung der Block-Polymer-Domänen auftritt;
m-2) Ätzen des Blockcopolymers, wodurch der stark ätzbare Block des Copolymers entfernt wird und ein sich wiederholendes Muster in Nanometergröße in den Bereichen gebildet wird, in denen eine gerichtete Selbstanordnung des Blockcopolymers auf dem Substrat in Schritt l-2) auftrat.

16. Verfahren der Chemoepitaxie, der gerichteten Selbstanordnung einer Blockcopolymer-Schicht, die zur Erzeugung eines Bildes verwendet wird, umfassend die Schritte:
a-3) Bildung einer Beschichtung aus der Zusammensetzung nach Anspruch 12 auf einem Substrat, das einen Film bildet,
b-3) Brennen des Films bei einer Temperatur von 200°C bis 350°C für 1 bis 10 Minuten unter Bildung einer unlöslichen vernetzten Pinning-MAT-Schicht,
c-3) Aufbringen einer Beschichtung aus einer positiven oder negativen Photoresistschicht auf die vernetzte Pinning-MAT-Schicht,
d-3) Ausbilden eines negativen bzw. positiven Bildes in der negativen bzw. positiven Photoresistschicht, wodurch Bereiche gebildet werden, in denen das vernetzte Pinning durch den Photoresist bedeckt bzw. unbedeckt ist,
e-3) Ätzen mit einem Plasma, um die vernetzte Pinning-MAT-Schicht in den in Schritt d-3) unbedeckten Bereichen zu entfernen, wobei ein blankes Substrat zurückbleibt und die vernetzte Pinning-MAT-Schicht in den in Schritt d-3) bedeckten Bereichen zurückbleibt, wodurch eine gemusterte vernetzte Pinning-MAT-Schicht gebildet wird,
f-3) Beschichten der gemusterten vernetzten Pinning-MAT-Schicht mit einer neutralen Bürstenschichtbeschichtung,
g-3) Aushärten der neutralen Bürstenschichtbeschichtung und Wegwaschen mit einem Lösungsmittel, wobei eine ungepfropfte Neutralschicht gebildet wird, die in Bereichen des Substrats, die nicht von der gemusterten vernetzten Pinning-MAT-Schicht bedeckt sind, eine neutrale Bürstenleitschicht bildet, die auf dem Substrat eine Chemoepitaxie-Leitschicht bildet,
h-3) Auftragen einer Blockcopolymerlösung auf die Chemoepitaxie-Leitschicht, wobei eine Beschichtung aus Blockcopolymer gebildet wird,
i-3) Tempern der Beschichtung aus Blockcopolymer, um einen gerichtet selbstangeordnenden Film des Blockcopolymers auf der Chemoepitaxie-Leitschicht zu bilden,
j-3) Ätzen des Blockcopolymers, wodurch der stark ätzbare Block des Copolymers entfernt wird und ein sich wiederholendes Muster in Nanometergröße in den Bereichen gebildet wird, in denen die gerichtete Selbstanordnung des Blockcopolymers auf dem Substrat in Schritt h-3) stattgefunden hat.

17. Verwendung des Copolymers nach einem beliebigen der Ansprüche 1 bis 11 oder der Zusammensetzung nach Anspruch 12 zur Beschichtung eines Substrats, vorzugsweise in einem Chemoepitaxieverfahren.

## Revendications

1. Copolymère statistique dont les motifs répétitifs comprennent des motifs répétitifs de structure (I), (II) et (III), dans lesquelles R₁ et R₂ sont indépendamment un alkyle en C-1 à C-4, x et y sont indépendamment le nombre de R₁ et R₂ qui indépendamment vont d'un entier de 0 à 3, R₃ est un alkyle en C-1 à C-4, et R₄ est choisi parmi un alkyle primaire en C-2 à C-10 ou un fragment comprenant un arène choisi dans le groupe constitué par un groupement biphényle substitué ou non substitué, un groupement phényle substitué ou non substitué et un groupement benzylique substitué ou non substitué et m, n et o sont respectivement le nombre de motifs répétitifs des structures (I), (II) et (III), où le % en moles du motif répétitif de structure (I) est dans la plage de 60 à 95 % en moles, le % en moles du motif répétitif de la structure (II) est dans la plage de 5 à 25 % en moles, le % en moles du motif répétitif de la structure (III) est dans la plage de 2 à 18 % en moles, la somme des % en moles de ces motifs répétitifs étant inférieure à 100 % en moles, si d'autres motifs répétitifs différents sont présents, ou étant égale à 100 % en moles si seulement les motifs répétitifs des structures (I), (II) et (III) sont présents, et en outre où ledit copolymère statistique a une polydispersité dans la plage de 1,25 à 1,80 et a un Mw, déterminé par chromatographie à perméation de gel étalonnée avec des étalons de polystyrène, qui est dans la plage de 30 000 à 45 000 daltons, et ledit copolymère statistique est exempt de groupes terminaux réactifs comprenant un groupement alcool benzylique,

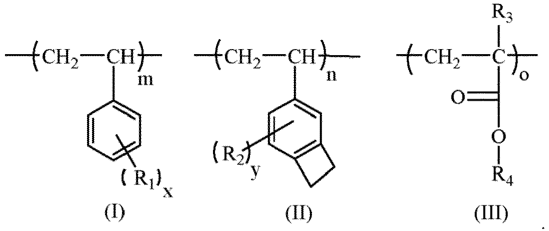

2. Copolymère statistique selon la revendication 1, dont les motifs répétitifs sont constitués essentiellement de motifs répétitifs de structure (I), (II) et (III).

3. Copolymère statistique selon la revendication 1 ou 2, dont les motifs répétitifs sont constitués de motifs répétitifs de structure (I), (II) et (III), où la somme des % en moles des motifs répétitifs (I), (II) et (III) est égale à 100 % en moles.

4. Copolymère statistique selon l'une quelconque des revendications 1 à 3, dans lequel le motif répétitif de structure (III) est dans la plage de 2,5 % en moles à 16 % en moles, et/ou le motif répétitif de structure (II) est dans la plage de 6 % en moles à 23 % en moles, et/ou le motif répétitif de structure (I) est dans la plage de 62 % en moles à 93 % en moles.

5. Copolymère statistique selon l'une quelconque des revendications 1 à 4, dans lequel le motif répétitif de structure (I) est dans la plage de 60 % en moles à 90 % en moles, le motif répétitif de structure (II) est dans la plage de 7 % en moles à 20 % en moles et le motif répétitif de structure (III) est dans la plage de 3 % en moles à 15 % en moles.

6. Copolymère statistique selon l'une quelconque des revendications 1 à 5, dans lequel x est 0 ou y est 0 ou x et y sont 0.

7. Copolymère statistique selon l'une quelconque des revendications 1 à 6, dans lequel R₃ est CH₃.

8. Copolymère statistique selon l'une quelconque des revendications 1 à 7, dans lequel R₄ est un alkyle primaire en C-3 à C-7.

9. Copolymère statistique selon l'une quelconque des revendications 1 à 8, dans lequel R₄ est un alkyle primaire en C-2 à C-6.

10. Copolymère statistique selon l'une quelconque des revendications 1 à 7, dans lequel R₄ est n-butyle, n-propyle, éthyle ou [1,1'-biphényl-4-yle].

11. Copolymère statistique selon l'une quelconque des revendications 1 à 7, dans lequel les motifs répétitifs ont les structures (Ia), (IIa) et (IIIa) ; 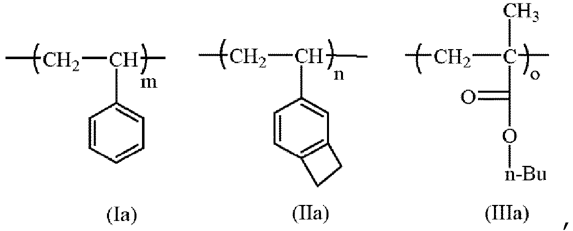 ou
(Ia), (IIa) et (IIIa-1) ; 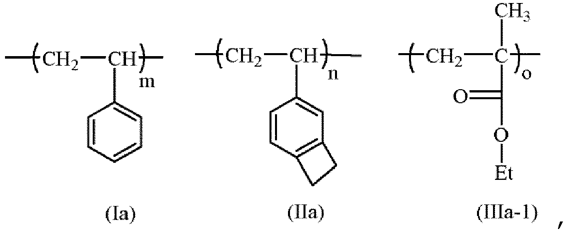 ou
(Ia), (IIa) et (IIIb) ; 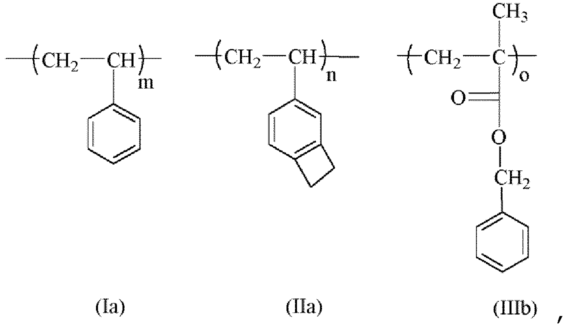 ou
(Ia), (IIa) et (IIIc) ; 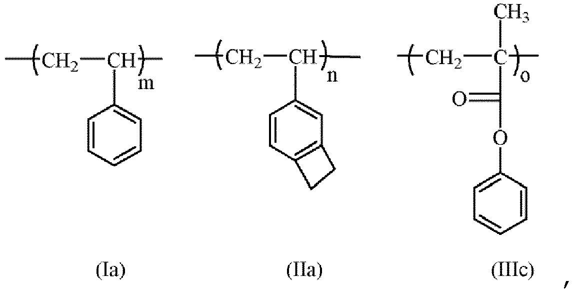 ou
(Ia), (IIa) et (IIId) ;

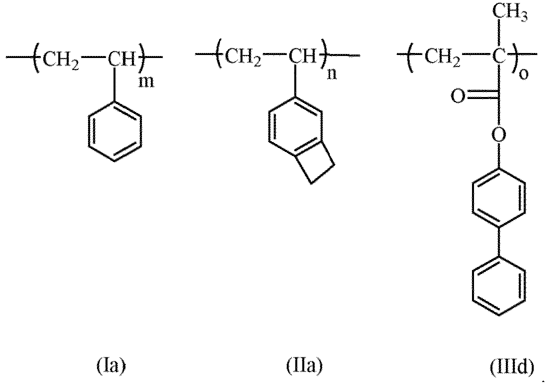

12. Composition comprenant le copolymère statistique selon l'une quelconque des revendications 1 à 11, et un solvant organique de coulée par centrifugation.

13. Procédé de formation d'une couche réticulée d'un copolymère sur un substrat comprenant les étapes :
a) formation d'un revêtement de la composition de la revendication 12 sur un substrat ;
b) chauffage du revêtement à une température dans la plage de 90 °C et 180 °C pour éliminer du solvant ;
c) chauffage du revêtement à une température dans la plage de 200 °C et 350 °C pour former une couche de revêtement de copolymère réticulé.

14. Procédé de chimioépitaxie, auto-assemblage dirigé d'une couche de copolymère à blocs utilisée pour former une image comprenant les étapes :
a-1) revêtement d'un substrat par un précurseur de polymère de couche neutre greffable pour former une couche revêtue 1 ;
b-1) chauffage de la couche revêtue 1 à une température de 90 °C à 180 °C pour éliminer du solvant ;
c-1) chauffage de la couche revêtue 1 après l'étape b-1) à une température de 200 °C à 350 °C pour effectuer le greffage ;
d-1) traitement de la couche revêtue 1 après l'étape c-1) par un solvant organique pour éliminer du polymère de couche neutre non greffé, laissant une couche neutre greffée insoluble sur le substrat ;
e-1) application d'une couche de photorésine négative sur la couche neutre greffée ;
f-1) formation d'un motif négatif dans la couche de photorésine, formant ainsi des zones dans lesquelles la couche neutre greffée est recouverte ou non recouverte par la photorésine, où le motif dans la photorésine est composé à la fois de motifs répétitifs de petite taille nanométrique et également de grandes zones de photorésine éliminées pendant le processus d'imagerie ne contenant pas de motifs répétitifs de taille nanométrique ;
g-1) gravure pour éliminer les zones de couche neutre non recouvertes à l'étape f-1) laissant le substrat nu dans ces zones ;
h-1) retrait de la photorésine du substrat après l'étape g-1), laissant un substrat à motifs dans lequel des zones du substrat laissées non recouvertes par la photorésine à l'étape f-1) sont exemptes d'une couche neutre greffée et les zones recouvertes par la photorésine à l'étape f-1) conservent la couche neutre greffée ;
i-1) revêtement du substrat à motifs par la composition de la revendication 12 pour former une couche revêtue 2 ;
j-1) chauffage de la couche revêtue 2 à une température de 90 °C à 180 °C pour éliminer du solvant ;
k-1) chauffage de la couche de revêtement 2 à une température dans la plage de 200 °C à 350 °C, laissant une couche de MAT de brochage réticulé insoluble sur le substrat dans les zones exemptes de couche neutre greffée créant un substrat comportant des zones de couche de MAT de brochage et des zones de couche neutre ;
l-1) application d'un revêtement d'un copolymère à blocs comprenant un bloc styrénique résistant à la gravure et un bloc aliphatique hautement gravable sur le substrat contenant une couche neutre à motifs et une couche de MAT de brochage, créant un substrat contenant à la fois une couche neutre à motifs et une couche de MAT de brochage à motifs ;
m-1) recuit de la couche de copolymère à blocs jusqu'à ce qu'un auto-assemblage dirigé se produise dans les motifs répétitifs de petite taille nanométrique du substrat, mais où aucune orientation perpendiculaire des domaines de polymère à blocs ne se produit dans les grandes zones contenant la couche de MAT de brochage réticulé ;
o-1) gravure du copolymère à blocs, éliminant ainsi le bloc hautement gravable du copolymère et formant un motif répétitif de taille nanométrique dans les zones où l'auto-assemblage dirigé du copolymère à blocs s'est produit sur le substrat à l'étape m-1).

15. Procédé de chimioépitaxie, auto-assemblage dirigé d'une couche de copolymère à blocs utilisée pour former une image, comprenant les étapes :
a-2) formation d'un revêtement d'un précurseur de polymère de couche neutre qui est réticulable ou qui est à la fois réticulable et greffable sur un substrat ;
b-2) chauffage du revêtement précurseur de la couche polymère neutre qui est réticulable ou du revêtement précurseur qui est à la fois réticulable et greffable à une température de 90 °C à 180 °C pour éliminer du solvant ;
c-2) chauffage du revêtement précurseur de polymère en couche neutre réticulable ou du revêtement précurseur de revêtement réticulable et greffable à une température de 200 °C à 330 C° pour former une couche neutre réticulée ou une couche neutre réticulée et greffée ;
d-2) fourniture d'un revêtement d'une couche de photorésine sur la couche neutre réticulée ou sur la couche neutre réticulée et greffée ;
e-2) formation d'un motif négatif dans la couche de photorésine, formant ainsi des zones dans lesquelles la couche neutre réticulée ou réticulée et greffée est recouverte ou non recouverte par la photorésine, où le motif dans la photorésine est composé à la fois de motifs répétitifs de petite taille nanométrique et également de grandes zones de photorésine éliminées pendant le processus d'imagerie ne contenant pas de motifs répétitifs de taille nanométrique ;
f-2) gravure avec un plasma pour éliminer dans les zones de couche neutre non recouvertes à l'étape e-2), éliminant une couche neutre réticulée ou réticulée et greffée laissant le substrat nu dans les zones non recouvertes à l'étape e-2) ;
g-2) retrait de la photorésine du substrat après l'étape f-2), laissant un substrat à motifs dans lequel des zones du substrat laissées non recouvertes par la photorésine à l'étape e-2) sont exemptes de couche neutre réticulée ou réticulée et greffée et les zones recouvertes par la photorésine à l'étape f2) conservent la couche neutre réticulée ou réticulée et greffée ;
h-2) revêtement du substrat à motifs par la composition de la revendication 12 pour former une couche revêtue 3 ; i-2) chauffage de la couche revêtue 3 à une température de 90 °C à 180 °C pour éliminer du solvant ;
j-2) chauffage de la couche de revêtement 3 à une température dans la plage de 200 °C à 350 °C, laissant une couche de MAT de brochage réticulé insoluble sur le substrat dans les zones exemptes de couche neutre greffée, créant un substrat contenant à la fois des zones de couche de MAT de brochage et des zones de couche neutre ;
k-2) application d'un revêtement d'un copolymère à blocs comprenant un bloc styrénique résistant à la gravure et un bloc aliphatique hautement gravable sur le substrat contenant une couche neutre à motifs et une couche de MAT de brochage ;
l-2) recuit de la couche de copolymère à blocs jusqu'à ce qu'un auto-assemblage dirigé se produise dans les motifs répétitifs de petite taille nanométrique du substrat, mais où aucune orientation perpendiculaire des domaines de polymère à blocs ne se produit dans les grandes zones contenant la couche de MAT de brochage réticulé ;
m-2) gravure du copolymère à blocs, éliminant ainsi le bloc hautement gravable du copolymère et formant un motif répétitif de taille nanométrique dans les zones où l'auto-assemblage dirigé du copolymère à blocs s'est produit sur le substrat à l'étape 1-2).

16. Procédé de chimioépitaxie, auto-assemblage dirigé d'une couche de copolymère à blocs utilisée pour former une image, comprenant les étapes :
a-3) formation d'un revêtement de la composition de la revendication 12, sur un substrat formant un film,
b-3) cuisson dudit film à une température de 200 °C à 350 °C pendant 1 à 10 minutes pour former une couche insoluble de MAT de brochage réticulé,
c-3) fourniture d'un revêtement d'une couche de photorésine positive ou négative sur la couche de MAT de brochage réticulé,
d-3) formation d'une image négative ou positive respectivement dans une couche de photorésine négative ou positive, formant ainsi des zones dans lesquelles le brochage réticulé est recouvert ou découvert par la photorésine,
e-3) gravure avec un plasma pour éliminer la couche de MAT de brochage réticulé dans les zones non recouvertes à l'étape d-3) laissant le substrat nu et laissant la couche de MAT de brochage réticulé dans les zones laissées recouvertes à l'étape d-3), formant une couche de MAT de brochage réticulé à motifs,
f-3) revêtement de ladite couche de MAT de brochage réticulé à motifs par un revêtement de couche de brosse neutre,
g-3) durcissement dudit revêtement de brosse de couche neutre et élimination par lavage avec une couche neutre non greffée de solvant formant dans des zones dudit substrat non recouvertes par ladite couche de MAT de brochage réticulé à motifs, une couche de direction de brosse neutre se formant sur ledit substrat formant une couche de direction de chimioépitaxie,
h-3) revêtement sur ladite couche de direction de chimioépitaxie d'une solution de copolymère à blocs formant un revêtement de copolymère à blocs,
i-3) recuit dudit revêtement de copolymère à blocs pour former un film autoassemblé dirigé du copolymère à blocs sur ladite couche de direction de chimioépitaxie,
j-3) gravure du copolymère à blocs, éliminant ainsi le bloc hautement gravable du copolymère et formant un motif répétitif de taille nanométrique dans les zones où l'auto-assemblage dirigé du copolymère à blocs s'est produit sur le substrat à l'étape h-3).

17. Utilisation du copolymère selon l'une quelconque des revendications 1 à 11 ou de la composition selon la revendication 12, pour revêtir un substrat, de préférence dans un processus de chimioépitaxie.
